# EUROPEAN PATENT APPLICATION

(11) **EP 4 730 959 A1**
(43) Date of publication of application: **22.04.2026**
(21) Application number: 25166785.3
(22) Date of filing: 27.03.2025
(51) Int. Cl.: H10F 10/166, H10F 71/00

(54) **SOLAR CELL, PREPARATION METHOD THEREOF, AND PHOTOVOLTAIC MODULE**

(30) Priority: 21.10.2024 CN 202411465985
(71) Applicant: Trina Solar Co., Ltd, Changzhou, Jiangsu 213031 (CN)
(72) Inventor: LIU, Chengfa, 213031 Changzhou (CN); ZHOU, Binbin, 213031 Changzhou (CN); LI, Zhenglin, 213031 Changzhou (CN); LV, Dongyun, 213031 Changzhou (CN)
(74) Representative: Arnold & Siedsma

(57) **Abstract**

The present disclosure relates to a solar cell, a preparation method thereof, and a photovoltaic module. The solar cell includes a substrate including a first surface, a passivating contact structure disposed on a part of the first surface, and a first electrode disposed on a side of the passivating contact structure away from the substrate and electrically connected to the passivating contact structure. A marking portion is disposed on a part of the passivating contact structure.

## Description

### TECHNICAL FIELD

The present application relates to the technical field of photovoltaics, particularly to a solar cell, a preparation method thereof, and a photovoltaic module.

### BACKGROUND

In order to reduce the recombination rate, prolong the lifetime of minority carriers, and improve the photoelectric conversion efficiency of a solar cell, the substrate of the solar cell is commonly subjected to passivation treatment in related art. A passivating contact layer is formed on the surface of the substrate to reduce the carrier recombination at the substrate surface, thereby reducing the influence caused by the defects in the substrate.

However, most passivating contact structures have significant parasitic absorption of incident light, resulting in a decrease in the photogenerated current of the solar cell, and thus affecting the efficiency of the solar cell. In order to address this issue, the passivating contact structure may be patterned to reduce its area, thereby reducing the parasitic absorption of incident light. The manufacturing process of the solar cell with the patterned passivating contact structure is relatively complex and requires relatively high precision. Marking points as positioning references are often formed on the surface of the cell to ensure that an electrode paste can be accurately printed on the patterned passivating contact structure.

However, the issue exists in the prior art is that the recognition accuracy for the marking points is relatively low, hindering an accurate printing of the electrode paste on the passivating contact structure, and thus reducing the yield of the solar cell.

### SUMMARY

Therefore, there is a need to provide a solar cell with relatively high reliability in capturing position of a marking portion and a high preparation yield, a preparation method thereof, and a photovoltaic module.

A first aspect of embodiments of the present application provides a solar cell, including:
a substrate including a first surface;
a passivating contact structure disposed on a part of the first surface; and
a first electrode disposed on a side of the passivating contact structure away from the substrate and electrically connected to the passivating contact structure;
wherein a marking portion is disposed on a part of the passivating contact structure.

In an embodiment, an orthographic projection of the marking portion on the first surface does not overlap with an orthographic projection of the first electrode on the first surface.

In an embodiment, the marking portion is configured to serve as a positioning reference during formation of the first electrode.

In an embodiment, the first electrode includes a plurality of first sub-electrodes and a plurality of second sub-electrodes, the plurality of first sub-electrodes are spaced apart from each other in a first direction, each of the plurality of first sub-electrodes is connected to at least two second sub-electrodes, and the at least two second sub-electrodes are spaced apart from each other in a second direction;
the marking portion is at least partially located between two adjacent second sub-electrodes, and the two adjacent second sub-electrodes are connected to the same first sub-electrode; the first direction and the second direction intersect with each other and are both perpendicular to a thickness direction of the solar cell.

In an embodiment, the marking portion is spaced apart from the two second sub-electrodes adjacent to the marking portion.

In an embodiment, an orthographic projection of the marking portion on the first surface is in contact or overlaps with an orthographic projection of at least one second sub-electrode adjacent to the marking portion on the first surface.

In an embodiment, the first surface includes one or a plurality of first regions and one or a plurality of passivated contact regions;
the passivating contact structure includes one or a plurality of first passivating contact structures and one or a plurality of second passivating contact structures;
the first passivating contact structure and the second passivating contact structure are respectively disposed in the corresponding passivated contact regions, and an orthographic projection of the second passivating contact structure does not overlap with an orthographic projection of the first passivating contact structure on the first surface;
the first electrode is disposed on the first passivating contact structure away from the substrate; the marking portion is disposed on a side of the second passivating contact structure.

In an embodiment, edges of the plurality of first passivating contact structures respectively define a plurality of accommodation regions;
each second passivating contact structure is located in a corresponding accommodation region.

In an embodiment, the plurality of first passivating contact structures are spaced apart from each other;
each first passivating contact structure includes a first contact region and a plurality of second contact regions extending from the first contact region in a direction away from the first contact region;
the accommodation region is defined between two adjacent second contact regions, and the two adjacent second contact regions are connected to the same first contact region.

In an embodiment, the plurality of first contact regions of the plurality of first passivating contact structures are spaced apart from each other in a first direction, and the plurality of second contact regions connected to the same first contact region are spaced apart from each other in a second direction, the first direction and the second direction intersect with each other and are both perpendicular to a thickness direction of the solar cell.

In an embodiment, the first electrode includes a plurality of first sub-electrodes and a plurality of second sub-electrodes, each first sub-electrode is connected to at least two second sub-electrodes, and the at least two second sub-electrodes are spaced apart from each other in the second direction; the plurality of first sub-electrodes are disposed on the first contact regions in one-to-one correspondence and located at a surface of the first contact regions away from the substrate, and the plurality of second sub-electrodes are disposed on the second contact regions in one-to-one correspondence and located at a surface of the second contact regions away from the substrate, the second contact regions being connected to the first contact regions;
the second passivating contact structure is located between two adjacent second sub-electrodes which are adjacent in the second direction, and the two adjacent second sub-electrodes are connected to the same first sub-electrode.

In an embodiment, each first passivating contact structure includes a plurality of third contact regions, the plurality of third contact regions are spaced apart from each other, and the accommodation region is disposed between two adjacent third contact regions;
the first electrode includes a plurality of third sub-electrodes, and the third sub-electrodes are disposed in the third contact regions in one-to-one correspondence.

In an embodiment, at least one of the first passivating contact structure and the second passivating contact structure includes a first tunneling oxide layer and a first conductive doped polysilicon layer stacked on each other, and the first tunneling oxide layer is disposed on the first surface.

In an embodiment, the first passivating contact structure and the second passivating contact structure are spaced apart from each other.

In an embodiment, the marking portion is spaced from an edge of a corresponding second passivating contact structure.

In an embodiment, the marking portion is a plurality of marking portions;
the plurality of marking portions are configured to locate a geometric center of the solar cell.

In an embodiment, the marking portion includes a first groove;
the first groove extends to an interior of the second passivating contact structure; and/or
the first groove extends to and terminated at a boundary position between the second passivating contact structure and the first surface in the passivated contact region in a thickness direction of the solar cell; and/or
the first groove extends to an interior of the substrate in the passivated contact region.

In an embodiment, the first groove extends into the substrate in the passivated contact region, a maximum vertical distance D1 between a bottom wall of the first groove and the first surface in the passivated contact region satisfies: D1>1 µm.

In an embodiment, the bottom wall of the first groove includes a central region and an over-etched region adjacent to an edge of the central region;
a height of the over-etched region relative to a second surface of the substrate is lower than a height of the central region relative to the second surface;
the second surface is opposite to the first surface.

In an embodiment, a width W1 of the first groove satisfies: W1<100 µm.

In an embodiment, the marking portion further includes a transitional treatment region located between an edge of an opening of the first groove and an edge of an adjacent second passivating contact structure;
a reflectivity of a surface of the transitional treatment region away from the substrate is greater than a reflectivity of a surface of the second passivating contact structure away from the substrate.

In an embodiment, a surface of the transitional treatment region away from the substrate includes a plurality of protrusions;
heights of the plurality of projections relative to the second surface of the substrate gradually increase from the edge of the opening of the first groove to the edge of the adjacent second passivating contact structure.

In an embodiment, a roughness of a surface of the transitional treatment region away from the substrate is smaller than a roughness of a surface of the second passivating contact structure away from the substrate.

In an embodiment, the transitional treatment region includes a fusion of a first material and a second material;
wherein the first material is a passivating contact material from the second passivating contact structure, and the second material is a substrate material from the substrate.

In an embodiment, the surface of the transitional treatment region away from the substrate is lower than the surface of the second passivating contact structure away from the substrate by D0, where 50 nm<D0<1 µm.

In an embodiment, a size W2 of the marking portion in a width direction of the first groove satisfies: W2<120 µm.

In an embodiment, a third structure is disposed on the surface of the second passivating contact structure away from the substrate;
the third structure is disposed around the marking portion, and a reflectivity of a surface of the third structure away from the substrate is greater than the reflectivity of the surface of the second passivating contact structure away from the substrate.

In an embodiment, the reflectivity of the surface of the third structure away from the substrate, the reflectivity of the surface of the transitional treatment region away from the substrate, and the reflectivity of the bottom wall of the first groove increase in sequence.

In an embodiment, an outer contour of the first groove is in a circular or annular shape; or
the first groove includes at least two groove segments intersecting with each other.

In an embodiment, the first surface includes a plurality of first regions and at least one passivated contact region;
at least some of the first regions each are surrounded and defined by the passivated contact region.

In an embodiment, the first surface in the first region is more adjacent to a second surface of the substrate than the first surface in the passivated contact region, and the second surface is opposite to the first surface.

In an embodiment, a vertical distance D2 between the first surface in the first region and the first surface in the passivated contact region satisfies: D2>1 µm.

In an embodiment, the marking portion includes a first groove, and a vertical distance D1 between a bottom wall of the first groove and the first surface in the passivated contact region and D2 satisfies: D2≤D1.

In an embodiment, the solar cell includes a plurality of side surfaces, at least some of the side surfaces are cut surfaces formed by cutting.

A second aspect of the embodiments of the present application provides a method for preparing a solar cell, including:
providing a panel including a substrate, a passivating contact material layer, and a dielectric layer, the passivating contact material layer and the dielectric layer being sequentially stacked on a first surface of the substrate, the first surface of the substrate including a first region and a passivated contact region;
patterning a part of the dielectric layer covering the first region, and forming a marking structure at a position on the dielectric layer covering the passivated contact region, the marking structure extending at least into the passivating contact material layer;
removing a part of the passivating contact material layer located in the first region by using the part of the dielectric layer covering the passivated contact region, in the dielectric layer that has been patterned and has been formed with the marking structure, as a mask and removing the dielectric layer to form the marking structure into a marking portion; and
forming a first passivation layer on a side of the passivating contact material layer away from the substrate, and forming a first electrode at a position on the first passivation layer covering the passivated contact region by using the marking portion as a positioning reference.

In an embodiment, the step of forming the marking structure at the position on the dielectric layer covering the passivated contact region specifically includes:
locally scanning the position of the dielectric layer covering the passivated contact region with a first laser to form the marking structure.

In an embodiment, the step of patterning the part of the dielectric layer covering the first region specifically includes:
entirely scanning the position of the dielectric layer covering the first region with a second laser;
wherein a laser spot of the second laser is larger than a laser spot of the first laser, and a power of the second laser is higher than a power of the first laser.

In an embodiment, a diameter of the laser spot of the first laser is less than 120 µm, and the power of the first laser is in a range from 10 W to 100 W;
a diameter of the laser spot of the second laser is greater than 150 µm, and the power of the second laser is in a range from 40 W to 200 W.

In an embodiment, the step of locally scanning the position of the dielectric layer covering the passivated contact region with the first laser specifically includes:
reciprocally scanning the dielectric layer in a first path and reciprocally scanning the dielectric layer in a second path with the first laser to form the marking structure with a cross-shaped outer contour in the dielectric layer, wherein the first path and the second path intersect with each other and both are straight-line paths; or
scanning the dielectric layer in an annular path with the first laser to form the marking structure with an annular outer contour; or
scanning the dielectric layer in a circular region with the first laser to form the marking structure with a circular outer contour.

In an embodiment, the marking portion includes a first groove;
The steps of removing the part of the passivating contact material layer located in the first region by using the part of the dielectric layer covering the passivated contact region, in the dielectric layer that has been patterned and has been formed with the marking structure, as a mask, and removing the dielectric layer to form the marking structure into a marking portion include:
wet etching to remove the part of the passivating contact material layer located in the first region, and removing the dielectric layer, thereby forming the first groove in the passivating contact material layer covering the passivated contact region.

In an embodiment, the marking structure further includes a transitional treatment region located at an edge of an opening of the first groove, and the first laser has a greater energy intensity at a central local area of a laser spot than that at an edge area of the laser spot;
through the wet etching, in the passivating contact material layer, a region treated by the central local area of the laser spot comprises two parts, wherein one of the two parts forms the first groove, and the other of the two parts and a region treated by the edge area of the laser spot forms the transitional treatment region, the transitional treatment region includes a fusion of materials from the dielectric layer, the passivating contact material layer, and the substrate.

In an embodiment, a third structure is formed around the marking structure after the wet etching, a reflectivity of a surface of the third structure away from the substrate is greater than a reflectivity of a surface of the passivating contact material layer away from the substrate.

In an embodiment, the step of removing the part of the passivating contact material layer located in the first region by using the part of the dielectric layer covering the passivated contact region, in the dielectric layer that has been patterned and has been formed with the marking structure, as the mask further includes inwardly etching the substrate in the first region along a thickness direction of the substrate.

In an embodiment, the step of patterning the part of the dielectric layer covering the first region includes:
modifying the part of the dielectric layer covering the first region;
the step of removing the part of the passivating contact material layer located in the first region by using the part of the dielectric layer covering the passivated contact region, in the dielectric layer that has been patterned and has been formed with the marking structure, as the mask specifically includes:
wet etching to remove the part of the dielectric layer covering the first region and the part of the passivating contact material layer located in the first region.

In an embodiment, the step of patterning the part of the dielectric layer covering the first region includes:
removing the part of the dielectric layer covering the first region;
the step of removing the part of the passivating contact material layer located in the first region by using the part of the dielectric layer covering the passivated contact region, in the dielectric layer that has been patterned and has been formed with the marking structure, as the mask specifically includes:
wet etching to remove the part of the passivating contact material layer located in the first region.

In an embodiment, the above-mentioned method further includes cutting the solar cell into a plurality of solar cell bodies in a thickness direction thereof, wherein some solar cell bodies include zero marking portion, and some other solar cell bodies include one or more marking portions.

A third aspect of the embodiments of the present application provides a solar cell prepared by the above-mentioned method for preparing the solar cell.

A fourth aspect of the embodiments of the present application provides a photovoltaic module including at least one cell string, wherein the cell string includes at least two solar cells as described above.

### BRIEF DESCRIPTION OF THE DRAWINGS

FIG. 1 is a schematic structural view of a solar cell according to an embodiment of the present application.
FIG. 2 is a partial, top view of a solar cell according to an embodiment of the present application.
FIG. 3 is a schematic structural view of a solar cell according to another embodiment of the present application.
FIG. 4 is a schematic structural view of a solar cell according to yet another embodiment of the present application.
FIG. 5 shows an image of a marking portion in a solar cell according to an embodiment of the present application.
FIG. 6 is a partial, enlarged view of FIG. 5.
FIG. 7 is a schematic structural view of a marking portion in a solar cell according to another embodiment of the present application.
FIG. 8 is a schematic structural view of a marking portion in a solar cell according to yet another embodiment of the present application.
FIG. 9 is a schematic structural view of a marking portion in a solar cell according to still another embodiment of the present application.
FIG. 10 is a schematic structural view of a marking portion in a solar cell according to still another embodiment of the present application.
FIG. 11 is a schematic structural view of a marking portion in a solar cell according to still another embodiment of the present application.
FIG. 12 is a schematic structural view of a solar cell according to yet another embodiment of the present application.
FIG. 13 is a schematic structural view of a solar cell according to yet another embodiment of the present application.
FIG. 14 shows a flow chart of a method for preparing a solar cell according to an embodiment of the present application.
FIG. 15 is a schematic structural view of a panel in a method for preparing a solar cell according to an embodiment of the present application.
FIG. 16 is a schematic structural view of forming a marking structure in a method for preparing a solar cell according to an embodiment of the present application.
FIG. 17 is a schematic structural view of forming a marking portion in a method for preparing a solar cell according to an embodiment of the present application.
FIG. 18 is a schematic structural view of forming a first passivation layer in a method for preparing a solar cell according to an embodiment of the present application.
FIG. 19 shows an image of the marking structure shown in FIG. 16.
FIG. 20 shows an image of the marking portion shown in FIG. 17.
FIG. 21 is a graph showing heights at various positions of the marking portion shown in FIG. 5.
FIGs. 22A to 22D are schematic top views of solar cells according to embodiments of the present application.

### Reference signs:

100: solar cell; 101: panel;
10: substrate; 200: passivating contact structure; 20: first passivating contact structure; 2011: first contact region; 2012: second contact region; 201: first tunneling oxide layer; 202: first conductive doped polysilicon layer; 21: passivating contact material layer; 211: tunneling oxide material layer; 212: doped polysilicon material layer; 22: dielectric layer; 30: second passivating contact structure; 40: marking structure; 50: marking portion; 51: first groove; 510: groove segment; 511: protrusion structure; 52: transitional treatment region; 53: third structure; 60: first passivation layer; 70: second passivation layer; 81: first electrode; 810: first sub-electrode; 811: second sub-electrode; 82: second electrode; 90: doped conductive layer; 91: textured surface structure; 92: third passivating contact structure;
Y: first surface; E: second surface; J: passivated contact region; F: first region; B: first direction; C: second direction; G: accommodation region.

### DETAILED DESCRIPTION

The embodiments of the present application will be described in detail with reference to the accompanying drawings in order to make the objects, features, and advantages of the present application more apparent and understandable. Many specific details are disclosed in the following description to facilitate a comprehensive understanding of the present application. However, the present application can be implemented in various ways different from those described herein, and those skilled in the art may make similar improvements without departing from the scope of the present application. Therefore, the present application is not limited to the specific embodiments disclosed below.

In the description of the present application, it should be understood that the orientation or position relationships indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present application and simplify the description only, rather than indicating or implying that the apparatus or element referred to must have a particular orientation or be constructed and operated in a particular orientation, and therefore are not to be interpreted as limiting the present application.

In addition, the terms "first" and "second" are used for descriptive purposes only, and cannot be construed as indicating or implying a relative importance, or implicitly specifying the number of the indicated technical features. Thus, the quantity of the feature defined with "first" or "second" may explicitly or implicitly be at least one. In the description of the present application, "a plurality of' means at least two, such as two, three, etc., unless otherwise defined explicitly and specifically.

In the present application, unless otherwise specified and defined explicitly, the terms "install", "connect", "join", and "fix" should be interpreted in a broad sense. For example, unless otherwise defined explicitly, they may refer to a fixed connection, a detachable connection, or an integral connection, may refer to a mechanical connection or an electrical connection, and may refer to a direct connection, an indirect connection via an intermediate medium, an internal communication between two elements, or interaction between two elements. The specific meanings of these terms in the present application can be understood based on specific circumstances by those of ordinary skills in the art.

In the present application, unless otherwise specified and defined explicitly, a first feature, when expressed as being "on" or "under" a second feature, may be in direct contact with the second feature or in indirect contact with the second feature via an intermediate medium. Furthermore, a first feature, when expressed as being "over", "above" or "on top of" a second feature, may be located right above or obliquely above the second feature, or only located at a level higher than that of the second feature. A first feature, when expressed as being "below", "underneath" or "under" a second feature, may be located right below or obliquely below the second feature, or only located at a level lower than that of the second feature.

It should be noted that when an element is referred to as being "fixed to" or "arranged on" another element, it may be directly disposed on the other element or an intermediate element may exist. When an element is considered to be "connected to" another element, it may be directly connected to the other element or an intermediate element may also exist. The terms "vertical", "horizontal", "upper", "lower", "left", "right" and similar expressions used herein are only for illustrative purposes and are not intended to represent the only implementations.

Hereinafter, solar cells according to embodiments of the present application will be described with reference to the accompanying drawings. It should be noted that the embodiments of the present application are suitable for the solar cells employing passivating contact structures. In the present application, tunnel oxide passivated contact (TOPCon) cells are taken as examples of the solar cells for description, whereas the solar cells can be other types of cells employing the passivating contact structures, such as TOPCon-IBC (TBC) cells, etc. The solar cells of other types can have similar corresponding structures, and will not be repeatedly described herein.

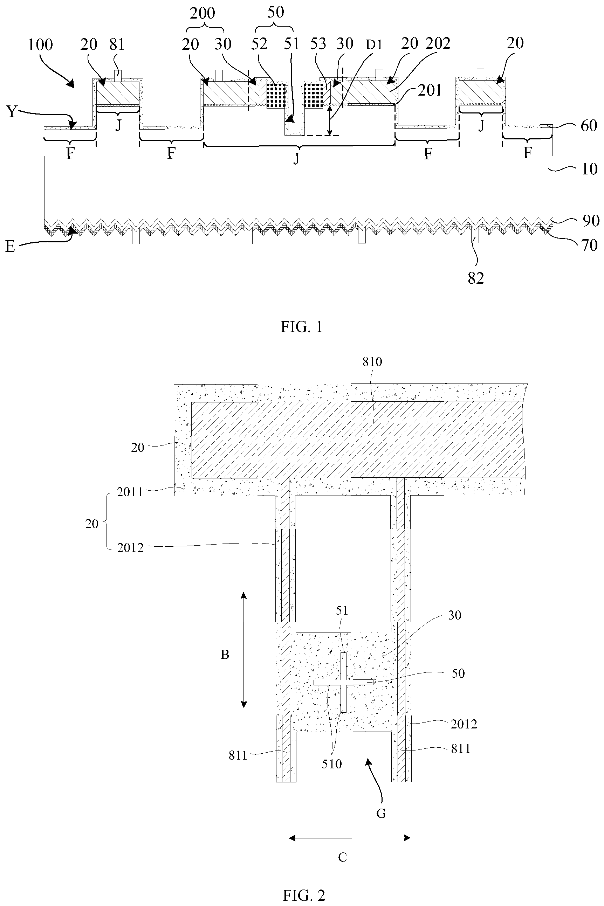

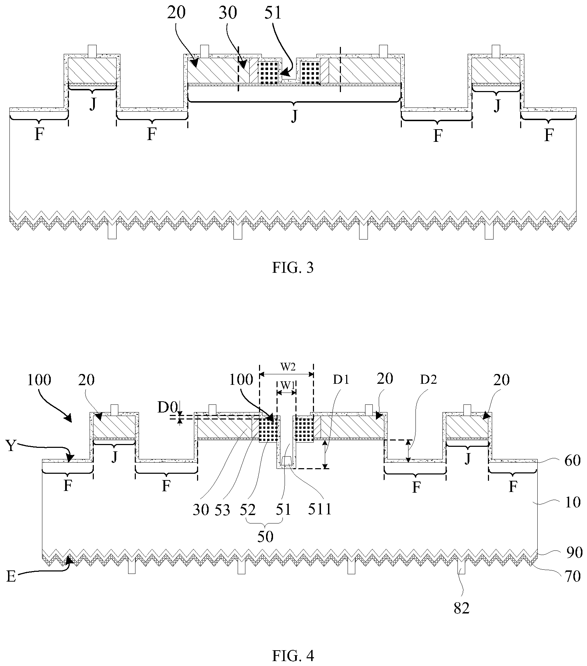

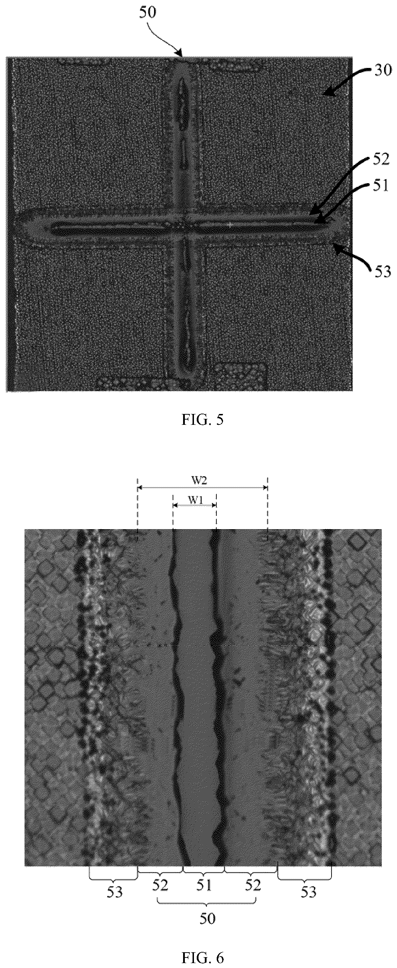

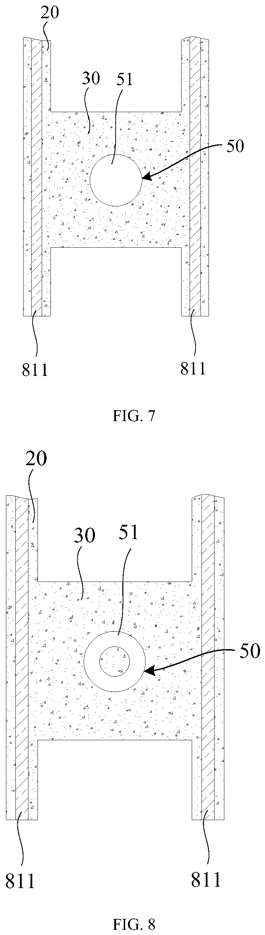

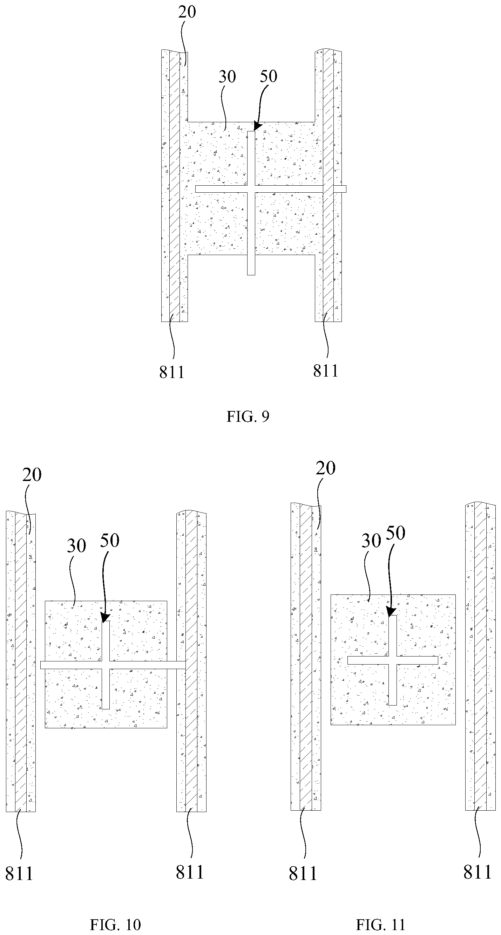

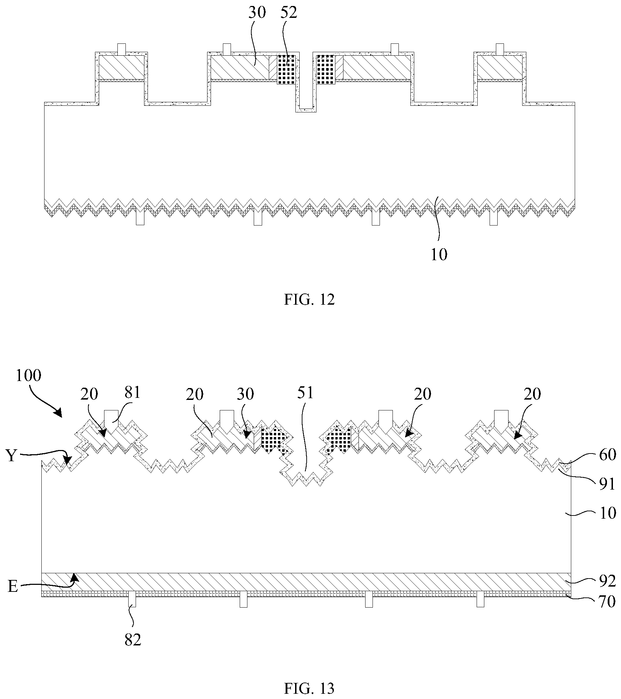

FIG. 1 is a schematic structural view of a solar cell according to an embodiment of the present application. FIG. 2 is a partial top view of a solar cell according to an embodiment of the present application. FIG. 3 is a schematic structural view of a solar cell according to another embodiment of the present application. FIG. 4 is a schematic structural view of a solar cell according to yet another embodiment of the present application. FIG. 5 shows an image of a marking portion in a solar cell according to an embodiment of the present application. FIG. 6 is a partial, enlarged view of FIG. 5. FIG. 7 is a schematic structural view of a marking portion in a solar cell according to another embodiment of the present application. FIG. 8 is a schematic structural view of a marking portion in a solar cell according to yet another embodiment of the present application. FIG. 9 is a schematic structural view of a marking portion in a solar cell according to still another embodiment of the present application. FIG. 10 is a schematic structural view of a marking portion in a solar cell according to still another embodiment of the present application. FIG. 11 is a schematic structural view of a marking portion in a solar cell according to still another embodiment of the present application. FIG. 12 is a schematic structural view of a solar cell according to yet another embodiment of the present application. FIG. 13 is a schematic structural view of a solar cell according to yet another embodiment of the present application.

Referring to FIG. 1 and FIG. 2, a solar cell 100 according to an embodiment of the present application includes a substrate 10, a passivating contact structure 200, and a first electrode 81.

The substrate 10 includes a first surface Y. The passivating contact structure 200 is disposed on a part of the first surface Y. The first electrode 81 is disposed on a side of the passivating contact structure 200 away from the substrate 10, and is electrically connected to the passivating contact structure 200. At least one marking portion 50 is disposed on a part of the passivating contact structure 200. The marking portion 50 can be configured to serve as a positioning reference during the formation of the first electrode 81. The marking portion 50 can extend inwardly or outwardly from the surface of the passivating contact structure 200, e.g., extend into the substrate 10 or protrude out from the passivating contact structure 200, or extend bidirectionally into the substrate 10 and out from the passivating contact structure 200. The inwardly extended marking portion 50 can be a groove. The outwardly extended marking portion 50 can be a protrusion.

Since the passivating contact structure 200 is disposed on a part of the first surface Y, the passivating contact structure 200 covers only a part of the first surface Y to form a localized passivating contact structure. The marking portion 50 is disposed on a part of the passivating contact structure 200 away from the substrate 10, and the marking portion 50 is configured to serve as a positioning reference during the formation of the first electrode 81. In other words, the marking portion 50 is disposed on and/or in the passivating contact structure 200, and a passivating contact material is retained around the marking portion 50. Compared with disposing the marking portion 50 outside the passivating contact structure 200, this structure creates a significant difference in the reflection ability between the marking portion 50 and the circumjacent background structure, allowing image capturing mechanisms, such as a camera, to capture the position of the marking portion 50 more easily and more accurately, thereby ensuring more precise positioning of the first electrode 81, and improving the yield of the solar cell 100.

In some embodiments, an orthographic projection of the marking portion 50 on the first surface Y does not overlap with an orthographic projection of the first electrode 81 on the first surface Y. Since the orthographic projection of the marking portion 50 on the first surface does not overlap with the orthographic projection of the first electrode 81 on the first surface, the marking portion 50 does not interfere with the first electrode 81.

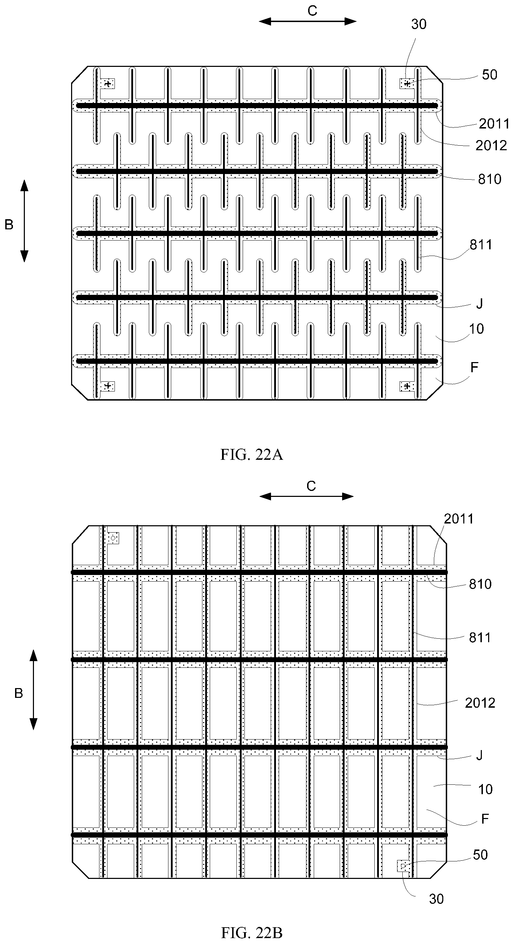

Specifically, the first surface Y can include one or more first regions F and one or more passivated contact regions J. Each first region F is defined by adjacent passivated contact region(s) J. Each passivated contact region J refers to the region of the first surface Y covered by the passivating contact structure 200. Each first region F refers to the region of the first surface Y not covered by the passivating contact structure 200. The regions of the first surface Y are the first region(s) F except the passivated contact region(s) J. As the marking portion 50 is disposed on a surface of a part of the passivating contact structure 200 away from the substrate 10, the marking portion 50 is also located in a passivated contact region J. In some embodiments, referring to FIG. 22A, the first surface Y includes a plurality of passivated contact regions J and a plurality of first regions F, the passivated contact regions J are spaced apart from each other, and two adjacent passivated contact regions J can be spaced apart from each other by a first region F therebetween.

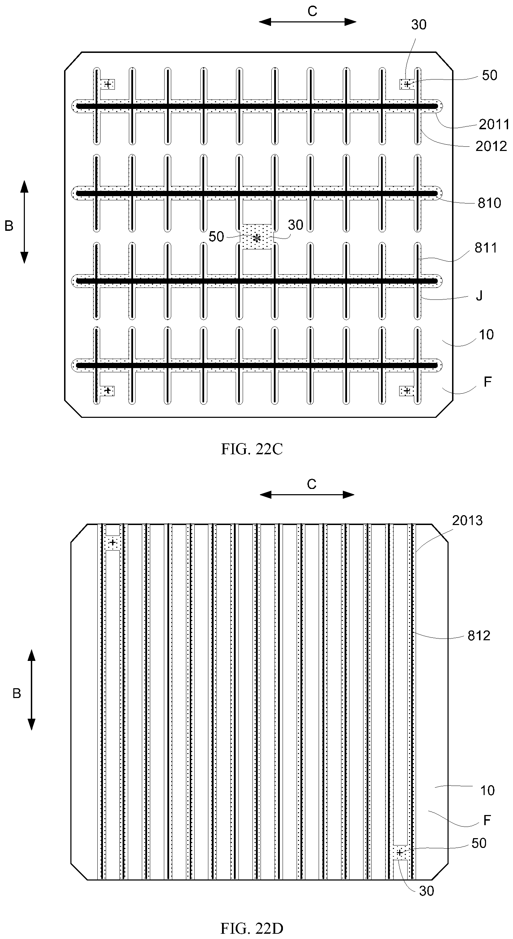

In some other embodiments, referring to FIG. 22B, the first surface Y can include a plurality of first regions F and at least one passivated contact region J. At least some of the first regions F each are surrounded and defined by the passivated contact region J. In these embodiments, the passivated contact region J can be a large integrated region, and the plurality of first regions F can be separately distributed within the passivated contact region J, so that the entire first surface Y is formed into a large mesh-shaped structure. Alternatively, referring to FIG. 22C, it can be a part of the first surface Y that is formed into a mesh-shaped structure, thereby forming at least one first region F, and the other part of the first surface Y can include a plurality of passivated contact regions J spaced apart from each other, and two adjacent passivated contact regions J can be spaced apart from each other by the first region F therebetween.

In the following description of the embodiments of the present application, the first surface Y including a plurality of first regions F and a plurality of passivated contact regions J, with the first regions F being defined by adjacent passivated contact regions J is taken as an example for description. The embodiments where the first surface Y including a plurality of first regions F and at least one passivated contact region J, with at least some of the first regions F each surrounded and defined by the passivated contact region J, have similar features and will not be repeatedly described herein.

The passivating contact structure 200 can include one or more first passivating contact structures 20 and one or more second passivating contact structures 30. The first passivating contact structure 20 refer to the part of the passivating contact structure 200 that is configured for arranging the first electrode 81. The second passivating contact structure 30 refer to the part of the passivating contact structure 200 that is configured for arranging the marking portion 50. The location of the first electrode 81 can be corresponding to at least part of the location of the first passivating contact structure 20, and the location of the marking portion 50 can be corresponding to at least part of the location of the second passivating contact structure 30. In some embodiments, each second passivating contact structure 30 is in contact with or spaced from adjacent first passivating contact structure 20. In FIG. 1, for the embodiment that the second passivating contact structure 30 is in contact with the adjacent first passivating contact structure 20, for convenience of observation, dashed lines are shown for distinguishing the first passivating contact structure 20 and the second passivating contact structure 30. The first passivating contact structure 20 and the second passivating contact structure 30 are disposed in corresponding passivated contact regions J, and the orthographic projection of the second passivating contact structure 30 on the first surface Y does not overlap with the orthographic projection of the first passivating contact structure 20 on the first surface Y. The first electrode 81 is disposed on the first passivating contact structure 20, at the side away from the substrate 10, and is electrically connected to the first passivating contact structure 20. The marking portion 50 is disposed in the second passivating contact structure 30, exposed from the side away from the substrate 10.

In the embodiments of the present application, the substrate 10 can further include a second surface E, and the second surface is opposite to the first surface Y.

As the first surface Y of the substrate 10 includes the passivated contact region J and the first region F, the first passivating contact structure 20 being disposed in the corresponding passivated contact region J, the second passivating contact structure 30 being disposed in the corresponding passivated contact region J, and the marking portion 50 being disposed in the second passivating contact structure 30, the marking portion 50 is located at a position corresponding to the passivated contact region J. Moreover, at the location around the marking portion 50, the passivating contact material from the second passivating contact structure 30 is retained. As a result, the difference in the reflectivity between the marking portion 50 and the circumjacent background structure is relatively significant, allowing image capturing mechanisms, such as a camera, to capture the position of the marking portion 50 more easily and more accurately.

Specifically, the first electrode 81 can include a plurality of sub-electrodes, which can be disposed on the side of the first passivating contact structures 20 away from the substrate 10, and in one-to-one correspondence with the first passivating contact structures 20. In addition, the orthographic projection of the second passivating contact structure 30 on the first surface Y does not overlap with the orthographic projection of the first passivating contact structure 20 on the first surface Y, meaning that the first passivating contact structure 20 and the second passivating contact structure 30 are respectively located in different areas of the passivated contact region J. The adjacent first and second passivating contact structures 20, 30 can be integrated or spaced apart from each other.

The first passivating contact structure 20 is disposed in the corresponding passivated contact region J. For example, a plurality of first passivating contact structures 20 can be disposed in multiple passivated contact regions J in one-to-one correspondence. Alternatively, more than one first passivating contact structure 20 can be disposed in one same passivated contact region J. In the embodiments of the present application, the first passivating contact structures 20 being disposed in the multiple passivated contact regions J in one-to-one correspondence is taken as an example for description, and other similar arrangements will not be repeatedly described herein.

The second passivating contact structure 30 is disposed in the corresponding passivated contact region J. For example, the second passivating contact structures 30 can be disposed in all or only some of the passivated contact regions J. In the passivated contact regions J having the second passivating contact structures 30 located therein, the second passivating contact structures 30 and the passivated contact regions J can be in one-to-one correspondence, or two or more second passivating contact structures 30 can be located in each passivated contact region J.

Specifically, the first surface Y can be a light-receiving surface of the solar cell 100, and the second surface E can be a back surface of the solar cell 100. Alternatively, the first surface Y can be a back surface of the solar cell 100, and the second surface E can be a light-receiving surface of the solar cell 100. In the example of FIG. 1, the first surface Y is a back surface of the solar cell 100.

In some embodiments of the present application, referring to FIG. 1, FIG. 2, and FIG. 22A, the passivated contact regions J can be spaced apart from each other in a preset direction, such as a first direction B.

Further, the first passivating contact structure 20 can have substantially the same layer structure as the second passivating contact structure 30. The first passivating contact structure 20 and the second passivating contact structure 30 either or both include a first tunneling oxide layer 201 and a first conductive doped polysilicon layer 202 stacked on each other. The first tunneling oxide layer 201 is disposed on the first surface Y, and can be located between the first surface Y and the first conductive doped polysilicon layer 202. The first conductive doped polysilicon layers 202 in both the first passivating contact structure 20 and the second passivating contact structure 30 have the same doping type, which can be the same as that of the substrate 10 (e.g., N-type or P-type). In some embodiments, such as the example of FIG. 1, the substrate 10 and the first conductive doped polysilicon layer 202 are both N-type.

The marking portion 50 can be configured to serve as a positioning reference during the formation of the first electrode 81, which means in the formation of the first electrode 81, there is a need to capture the marking portion 50 by an image capturing mechanism, such as a camera, to identify position information, so as to correspondingly adjust the metallization device, thereby achieve positioning between the first electrode 81 and the first passivating contact structure 20. In the embodiments of the present application, the metal paste can be precisely printed onto the predetermined area on the first passivating contact structure 20 due to the improved accuracy of capturing the marking portion 50, thereby forming the first electrode 81 on the first passivating contact structure 20.

In some embodiments of the present application, referring still to FIG. 1, a first passivation layer 60 can be further disposed on a side of the first passivating contact structures 20 and the second passivating contact structures 30 away from the substrate 10. The first passivation layer 60 functions for passivation and anti-reflection. The first passivation layer 60 can be a single layer or a multi-layer structure, and the material thereof can be aluminum oxide, silicon oxide, silicon nitride, silicon oxynitride, or the like. The first passivation layer 60 covers the first passivating contact structures 20, the second passivating contact structures 30, and the first regions F. In some embodiments, the first passivation layer 60 can cover the entire first surface Y.

Further, the solar cell 100 can include a doped conductive layer 90, a second passivation layer 70, and a second electrode 82 that are sequentially stacked on the second surface E of the substrate 10. The doped conductive layer 90 is configured to form a PN junction with the substrate 10. In the embodiments of the present application, the N-type substrate 10 is taken as an example for description, and in this case, the doped conductive layer 90 can be a P-type doped layer, such as a boron-doped conductive layer 90 (also referred to as a P+-type emitter).

The second passivation layer 70 can include, for example, a passivation layer and an anti-reflection layer (not shown) sequentially stacked on the doped conductive layer 90. Further, the second electrode 82 can be disposed on the second passivation layer 70, and electrically connected to the doped conductive layer 90.

In some embodiments of the present application, referring to FIG. 2, edges of the first passivating contact structures 20 define a plurality of accommodation regions G. Each second passivating contact structure 30 is located in a corresponding accommodation region G. In this way, the second passivating contact structure 30 can be seen as being embedded in the first passivating contact structure 20, not additionally occupying the effective area of the first surface Y, which is beneficial to reducing the overall area of the passivating contact structure 200 of the solar cell 100. The accommodation regions G are hollow regions in the first passivating contact structures 20, and the first surface Y is exposed from the accommodation regions G.

Only one first passivating contact structure 20 is shown in FIG. 2. In some embodiments of the present application, such as that shown in FIG. 22A, there are a plurality of first passivating contact structures 20, the plurality of first passivating contact structures 20 are spaced apart from each other.

Each first passivating contact structure 20 can include at least one first contact region 2011 and a plurality of second contact regions 2012 extending from the first contact region 2011 in a direction away from the first contact region 2011. The accommodation region G can be formed between two adjacent second contact regions 2012. The two adjacent second contact regions 2012 are connected to the same first contact region 2011, and the accommodation region G formed in this case can be a semi-open region.

It is to be understood that in some other embodiments, the two second contact regions 2012 which define the accommodation region G can be connected to different first contact regions 2011. Alternatively, the accommodation region G can be defined by two adjacent first contact regions 2011.

In some embodiments, the second passivating contact structure 30 can be disposed between the first passivating contact structure 20 and the edge of the solar cell 100, such as between the first contact region 2011 and the edge of the solar cell 100.

In some embodiments, the plurality of first contact regions 2011 of the plurality of first passivating contact structures 20 are spaced apart from each other in a first direction B, and the plurality of second contact regions 2012 connected to the same first contact region 2011 are spaced apart from each other in a second direction C, where the first direction B and the second direction C intersect with each other and are both perpendicular to a thickness direction of the solar cell 100. In some embodiments, the first direction B and the second direction C can be perpendicular to each other.

In some embodiments, the first electrode 81 includes a plurality of first sub-electrodes 810 and a plurality of second sub-electrodes 811. The first sub-electrodes 810 are spaced apart from each other in a first direction B. Each first sub-electrode 810 is connected to at least two second sub-electrodes 811, which are spaced apart from each other in the second direction C. The plurality of first sub-electrodes 810 are disposed on a surface of the first contact regions 2011 away from the substrate 10, and are in one-to-one correspondence with the first contact regions 2011. The plurality of second sub-electrodes 811 are disposed on a surface of the second contact regions 2012 away from the substrate 10, and are in one-to-one correspondence with the second contact regions 2012, the second contact regions 2012 being connected with the first contact regions 2011.

In some embodiments, the second passivating contact structure 30 is located between two second sub-electrodes 811 that are adjacent in the second direction C, and the two adjacent second sub-electrodes 811 are connected to the same first sub-electrode 810.

In some embodiments of the present application, the first sub-electrodes 810 can be busbars, and the second sub-electrodes 811 can be finger electrodes.

Further, referring to FIG. 22D, in some other embodiments, each of the first passivating contact structures 20 can include a plurality of third contact regions 2013, which are spaced apart from each other, and the accommodation region G can be disposed between two adjacent third contact regions 2013. In this case, the first passivating contact structure 20 includes only the third contact regions 2013. Correspondingly, the first electrode 81 can include a plurality of third sub-electrodes 812, and the third sub-electrodes 812 are disposed in the third contact regions in one-to-one correspondence. The third sub-electrodes 812 can be finger electrodes, and the solar cell 100 can be a solar cell 100 without a busbar.

Further, it can be understood that the marking portion 50 can be located at least partially between two second sub-electrodes 811 which are adjacent in the second direction C, and the two adjacent second sub-electrodes 811 can be connected to the same first sub-electrode 810.

Referring to FIG. 2, the marking portion 50 can be spaced apart from the two second sub-electrodes 811 adjacent to the marking portion 50, so as to minimize the interference between the second sub-electrode 811 and the marking portion 50 during the capturing process.

In some embodiments of the present application, referring still to FIG. 1 and FIG. 2, the marking portion 50 includes a first groove 51.

Specifically, referring to FIG. 1, the first groove 51 can extend along the thickness direction of the substrate 10 into an interior of the substrate 10 in the passivated contact region J. As such, the appearance of the marking portion 50 can be more distinct and easier to be captured by a camera.

Alternatively, referring to FIG. 3, the first groove 51 can extend into the passivated contact region J, that is, the first groove 51 can extend to and terminated at a boundary position between the second passivating contact structure 30 and the first surface Y in the passivated contact region J in a thickness direction of the solar cell 100.

Alternatively, the first groove 51 can extend to an interior of the second passivating contact structure 30.

Further, referring still to FIG. 1, when the first groove 51 extends into the substrate 10, a maximum vertical distance D1 between a bottom wall of the first groove 51 and the first surface Y in the passivated contact region J satisfies: D1>1 µm. The deep groove 51 can has a reflectivity significantly different from the surrounding structure, and thus is easier to be captured by a camera.

Specifically, D1 can be 5.1 µm, 6 µm, 8 µm, etc., which makes the first groove 51 in the marking portion 50 to be captured more easily.

Further, referring to FIG. 4, in some other embodiments, a protrusion structure 511 is disposed in a central region of the bottom wall of the first groove 51. In other words, the bottom wall of the first groove 51 includes the central region and an over-etched region adjacent to the edge of the central region. A height of the over-etched region relative to the second surface E of the substrate 10 is lower than a height of the central region relative to the second surface E, thereby forming the protrusion structure 511 in the central region of the bottom wall. The bottom wall of the first groove 51 can be, but not limited to, a flat surface. Alternatively, the bottom wall of the first groove 51 can be a curved surface, such as a concave surface, and can also be an irregular curved surface, etc., which is related to parameters of laser, such as energy and power.

Specifically, the marking portion 50 can be formed through laser treatment. When the energy of the center of the laser spot is relatively high, a melt-modified region, which is difficult to be etched, is formed on the bottom wall of the first groove 51. Therefore, in the subsequent process of wet etching, the etching speed at the center region of the bottom wall of the first groove 51 is lower than the etching speed at other regions, resulting in the protrusion structure 511 at the central region of the bottom wall of the first groove 51 higher than the other regions. As such, the first groove 51 in the marking portion 50 can be captured more easily compared with the first groove 51 with the flat bottom wall.

In some embodiments of the present application, a width W1 of the first groove 51 satisfies: W1<100 µm. It should be noted that, for convenience of observation, sizes involved in the present application are labeled in FIG. 4, and corresponding sizes of the solar cell 100 having various structures described in the embodiments of the present application are similar to those in FIG. 4, and will not be repeatedly labeled in other drawings.

In some embodiments, W1 satisfies: 5 µm≤W1≤50 µm, which can avoid excessive damage on the solar cell or adversely affect the efficiency.

In some embodiments of the present application, referring to FIG. 1, FIG. 4, FIG. 5, and FIG. 6, the marking portion 50 further includes a transitional treatment region 52 located between an edge of an opening of the first groove 51 and an edge of the adjacent second passivating contact structure 30. A reflectivity of a surface of the transitional treatment region 52 away from the substrate 10 is greater than a reflectivity of the surface of the second passivating contact structure 30 away from the substrate 10.

The transitional treatment region 52 includes a fusion of a first material and a second material, where the first material is a passivating contact material from the second passivating contact structure 30, and the second material is a substrate material from the substrate 10. In other words, the transitional treatment region 52 includes a fusion of the passivating contact material from the second passivating contact structure 30 and the material from the substrate 10. During the formation of the marking portion 50 with laser, when the laser spot etches the position corresponding to the first groove 51, the laser spot covers the position corresponding to both the first groove 51 and the transitional treatment region 52. When the energy at the center of the spot is relatively high, the first groove 51 is formed at the position corresponding to the high energy center, and the materials in the layers through which the laser passes, such as the passivating contact material in the second passivating contact structure 30 and the material in the substrate 10 can partially melt to form the fusion around the first groove 51, thereby forming the transitional treatment region 52 around the first groove 51.

In some embodiments of the present application, the surface of the transitional treatment region 52 away from the substrate 10 forms a plurality of protrusions. The heights of the tops of the plurality of projections relative to the second surface E of the substrate 10 gradually increase from the edge of the opening of the first groove 51 to the edge of the adjacent second passivating contact structure 30.

Further, a roughness of the surface of the transitional treatment region 52 away from the substrate 10 can be smaller than a roughness of the surface of the second passivating contact structure 30 away from the substrate 10.

In the embodiments of the present application, the height of the transitional treatment region 52 can be slightly less than that of the surrounding second passivating contact structure 30 to enhance recognizability.

In some embodiments, the surface of the transitional treatment region 52 away from the substrate 10 is lower than the surface of the second passivating contact structure 30 away from the substrate 10 by D0, where 50 nm<D0<1 µm. In this way, a relatively significant optical difference can be formed between the marking portion 50 and the surrounding region, which facilitates capturing the marking portion 50 by a camera. In the case that the surface of the transitional treatment region 52 away from the substrate 10 is lower than the surface of the second passivating contact structure 30 away from the substrate 10, the reference for comparison can be the second surface E.

In some embodiments of the present application, a size W2 of the marking portion 50 in a width direction of the first groove 51 satisfies: W2<120 µm.

Specifically, the size W2 is less than 90 µm, and can be, for example, 30 µm, 40 µm, 50 µm, 60 µm, 70 µm, or 80 µm.

In some embodiments, a third structure 53 is disposed on the surface of the second passivating contact structure 30 away from the substrate 10. The third structure 53 is disposed around the marking portion 50. A reflectivity of a surface of the third structure 53 away from the substrate 10 is greater than the reflectivity of the surface of the second passivating contact structure 30 away from the substrate 10.

The third structure 53 refers to a structure formed by the fusion of the layers sputtered around the marking portion 50 during the laser etching. Specifically, during the laser formation of the marking portion 50, when the laser spot etches the position corresponding to the first groove 51, the passivating contact material in the second passivating contact structure 30 and the material in the substrate 10 are partially melt and then sputtered onto the surface of the second passivating contact structure 30 around the transitional treatment region 52, thereby forming the third structure 53 around the transitional treatment region 52.

In some embodiments of the present application, the reflectivity of the surface of the third structure 53 away from the substrate 10, the reflectivity of the surface of the transitional treatment region 52 away from the substrate 10, and the reflectivity of the bottom wall of the first groove 51 increase in sequence. In the three surfaces, i.e., the surface of the third structure 53 away from the substrate 10, the surface of the transitional treatment region 52 away from the substrate 10, and the bottom wall of the first groove 51, the surface roughness decreases in sequence, and the smoothness increases in sequence, which make the reflectivity increase in sequence. As such, the marking portion 50, the transitional treatment region 52, and the third structure 53 can exhibit gradually increased optical differences than the material in the surrounding second passivating contact structure 30. Compared with the setting that the reflectivity of the three is the same, the transitional treatment region 52 and the third structure 53 have greater optical difference than the surrounding material, making the marking portion 50 to be more easily captured by a camera. As shown in FIG. 5 and FIG. 6, the formed third structure 53 is significantly different from the surrounding second passivating contact structure 30 in morphology. In addition, the third structure 53 is significantly different from the transitional treatment region 52 in morphology, and the transitional treatment region 52 is significantly different from the first groove 51 in morphology, which can be easily captured by a camera.

In some embodiments, referring still to FIG. 1 and FIG. 4, the first surface Y in the first regions F is more adjacent to the second surface E of the substrate 10 than the first surface Y in the passivated contact regions J. That is, the first surface Y in the first regions F is located lower than the first surface Y in the passivated contact regions J. During the formation of the first passivating contact structures 20 and the second passivating contact structures 30, a layer of doped polysilicon material is firstly formed on the entire first surface Y. Due to the diffusion of dopants, an inward diffusion layer is formed under the first surface Y of the substrate 10, which increases the carrier recombination rate. With the above structure, the inward diffusion layer in the first region F can be at least partially removed, which is beneficial to reducing the carrier recombination and improving the efficiency of the solar cell 100.

In some embodiments of the present application, a vertical distance D2 between the first surface Y in the first regions F and the first surface Y in the passivated contact regions J satisfies: D2>1 µm. As such, the inward diffusion layer can be effectively removed, thereby reducing the carrier recombination rate.

In some embodiments of the present application, the vertical distance D1 between the bottom wall of the first groove 51 and the first surface Y in the passivated contact regions J and D2 satisfies: D2≤D1.

Specifically, D2 can be, for example, 5 µm. Alternatively, in some embodiments, D2 is greater than D1.

In some embodiments of the present application, referring to FIG. 7 and FIG. 8, the outer contour of first groove 51 from a top view is in a circular or annular shape. Alternatively, the first groove 51 includes at least two groove segments 510 intersecting with each other, and the outer contour of each groove segment 510 from a top view can be in a strip shape. The number of the groove segments 510 can, but is not limited to, two (as shown in FIG. 2), and can be other values according to needs.

It should be noted that, in the embodiments of the present application, the outer contour of a component refers to the outer edge of the component as viewed from top of the solar cell 100. For example, the outer contour of the first groove 51 refers to the outer edge of the first groove 51 as viewed from top of the solar cell 100, and the outer contour of the groove segment 510 refers to the outer edge of the groove segment 510 as viewed from top of the solar cell 100.

In some embodiments of the present application, as shown in FIGs. 2, 7, 8, and 9, the first passivating contact structure 20 and the second passivating contact structure 30 can be connected to each other, e.g., in contact with each other. Alternatively, as shown in FIGs. 10 and 11, the first passivating contact structure 20 and the second passivating contact structure 30 can be spaced apart from each other.

In some embodiments, the number of marking portions 50 can be plural, and the plurality of marking portions 50 are configured to locate the geometric center of the solar cell. For example, when the number of marking portions 50 is four, the four marking portions 50 can be disposed at four corners of a rectangular or square solar cell 100. The present application is not limited thereto, and the number of marking portions 50 can be other values according to needs. One or more marking portions 50 can be disposed in each second passivating contact structure 30 according to needs.

In some embodiments of the present application, regardless of the number of marking portions 50 disposed on each second passivating contact structure 30, the number of second passivating contact structures 30 can be an even number. The even number of second passivating contact structures 30 can be divided into a plurality of groups, with two in each group. The two second passivating contact structures 30 in each group are disposed opposite to each other with the geometric center of the solar cell 100 as a reference. When the number of second passivating contact structures 30 is four, the four second passivating contact structures 30 can be disposed at four corners of the solar cell 100 in a rectangular or square shape. The present application is not limited thereto, and the number of the second passivating contact structure 30 can be other numbers according to needs.

In some embodiments such as those shown in FIGs. 2, 7, 8, and 11, the marking portion 50 is spaced apart from the two second sub-electrodes 811, so as to prevent the second sub-electrodes 811 from affecting the capturing of the marking portion 50.

In some embodiments, an orthographic projection of the marking portion 50 on the first surface Y is in contact or overlaps with an orthographic projection of at least one of the two second sub-electrode 811 adjacent to the marking portion 50 on the first surface Y. For example, as shown in FIGs. 9 and 10, the first groove 51 of the marking portion 50 extends beyond the range of the second passivating contact structure 30 and is in contact with the second sub-electrode 811.

In addition, the marking portion 50 can be spaced apart from, or in contact with, the edge of the corresponding second passivating contact structure 30, as long as the capture center of the marking portion 50 is located within the range of the second passivating contact structure 30.

In some embodiments of the present application, referring to FIG. 12, on the basis of the foregoing embodiments, the transitional treatment region 52 is further modified. For example, the transitional treatment region 52 can be flush with the surrounding second passivating contact structure 30, and that is, the surface of the transitional treatment region 52 away from the substrate 10 is flush with the surface of the second passivating contact structure 30 away from the substrate 10.

Referring to FIG. 13, on the basis of the foregoing embodiments, some embodiments of the present application further provide a solar cell 100 having another structure, which is a bifacial TOPCon cell structure. In the solar cell 100 shown in FIG. 13, the structures, shapes, positions, etc. of various components such as the marking portion 50, the first passivating contact structure 20, the second passivating contact structure 30, and the first electrode 81 are the same as those described in the above embodiments, and will not be repeatedly described herein.

In the solar cell 100 shown in FIG. 13, the first surface Y is a light-receiving surface, and the second surface E is a back surface. The entire first surface Y is textured into textured surface structures 91, and therefore, the bottom wall and the side wall of the first groove 51 are both provided with the textured surface structures 91.

A third passivating contact structure 92, instead of the doped conductive layer 90, and the second passivation layer 70 are sequentially stacked on the second surface E.

The third passivating contact structure 92 convers the entire second surface E. The third passivating contact structure 92 includes a third tunneling oxide layer and a third conductive doped polysilicon layer stacked on each other. The third tunneling oxide layer is disposed on the second surface E, located between the second surface E and the third conductive doped polysilicon layer. The doping type of the third conductive doped polysilicon layer in the third passivating contact structure 92 is opposite to the doping type of the first conductive doped polysilicon layers 202 in the first passivating contact structure 20 and the second passivating contact structure 30.

In addition, in some embodiments of the present application, the solar cell 100 can include a plurality of side surfaces, and at least some of the side surfaces can be cut surfaces formed by cutting. As such, the solar cell 100 has a structure formed by cutting.

A second aspect of the embodiments of the present application provides a method for preparing a solar cell 100, which can be used for preparing the above solar cells 100. That is, the solar cells 100 of the above-described embodiments can be prepared by the method for preparing a solar cell as described below.

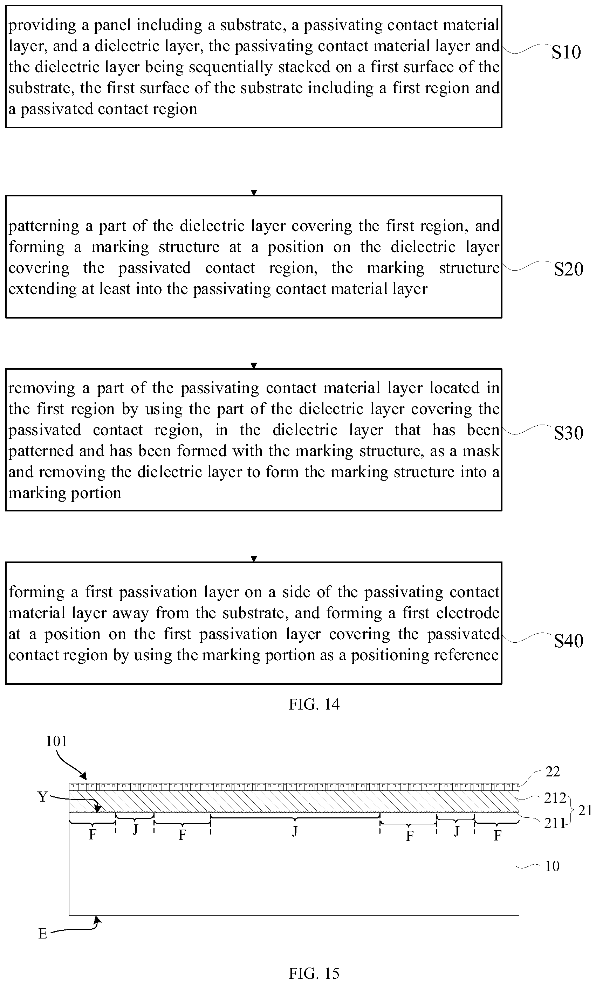

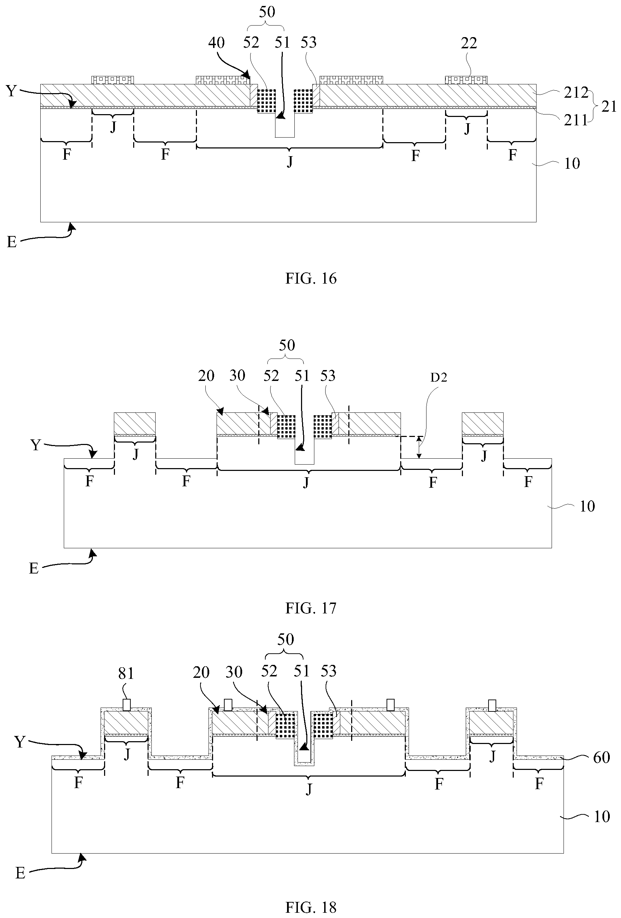

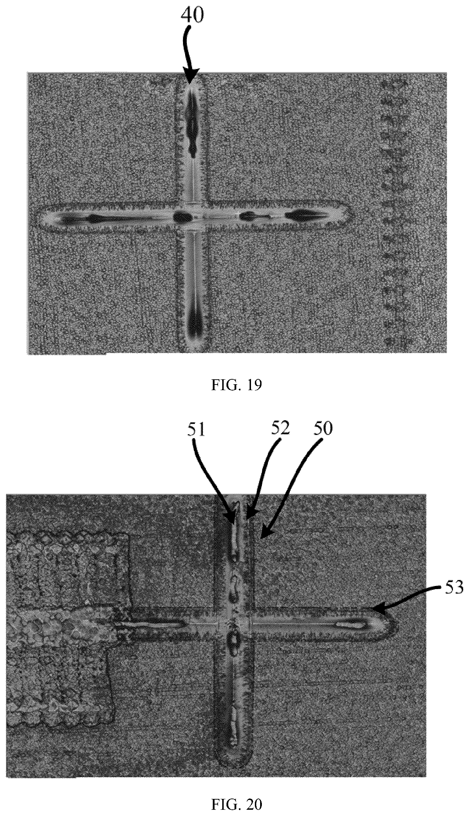

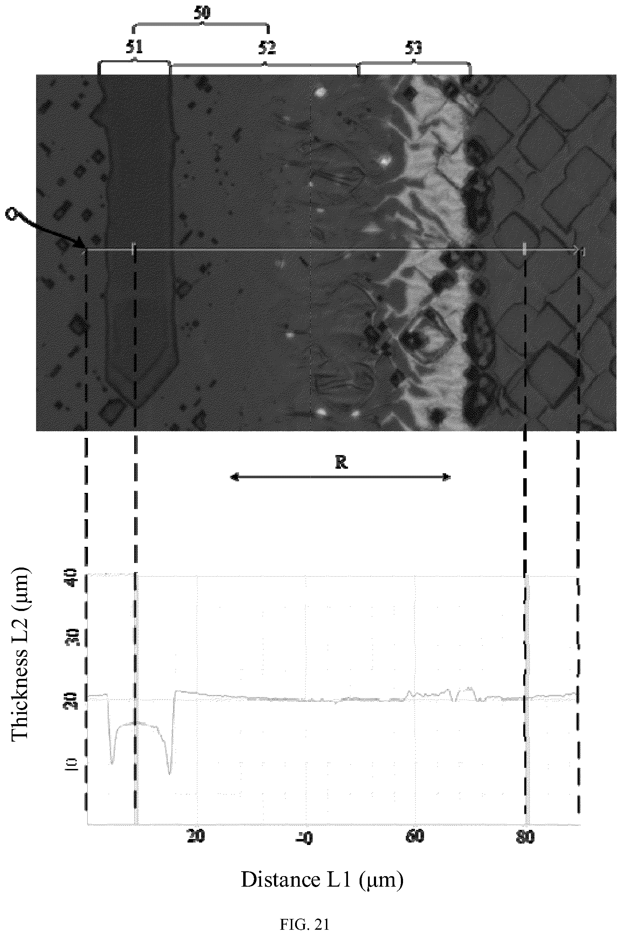

FIG. 14 shows a flow chart of a method for preparing a solar cell according to an embodiment of the present application. FIG. 15 is a schematic structural view of a panel in a method for preparing a solar cell according to an embodiment of the present application. FIG. 16 is a schematic structural view of forming a marking structure in a method for preparing a solar cell according to an embodiment of the present application. FIG. 17 is a schematic structural view of forming a marking portion in a method for preparing a solar cell according to an embodiment of the present application. FIG. 18 is a schematic structural view of forming a first passivation layer in a method for preparing a solar cell according to an embodiment of the present application. FIG. 19 shows an image of the marking structure shown in FIG. 16. FIG. 20 shows an image of the marking portion shown in FIG. 17. FIG. 21 is a graph showing heights at various positions of the marking portion shown in FIG. 5. The images shown in FIGs 5, 6, 19, 20, and 21 are optical microscopic images.

Referring to FIGs 14 to 21, in some embodiments of the present application, the method for preparing a solar cell includes:
S10: providing a panel, wherein the panel includes a substrate, a passivating contact material layer, and a dielectric layer, the passivating contact material layer and the dielectric layer are sequentially stacked on a first surface of the substrate, and the first surface of the substrate includes a first region and a passivated contact region;
S20: patterning the part of the dielectric layer covering the first region, and forming a marking structure at a position on the dielectric layer covering the passivated contact region, wherein the marking structure extends at least into the passivating contact material layer;
S30: removing the part of the passivating contact material layer located in the first region by using the part of the dielectric layer covering the passivated contact region, in the dielectric layer that has been patterned and has been formed with the marking structure, as a mask, and then removing the dielectric layer to form the marking structure into a marking portion; and
S40: forming a first passivation layer on a side of the passivating contact material layer away from the substrate, and forming a first electrode at a position on the first passivation layer covering the passivated contact region by using the marking portion as a positioning reference.

In the above technical solution, the part of the dielectric layer 22 covering the first region F is patterned, and the marking structure 40 is formed at the position on the dielectric layer 22 covering the passivated contact region J. The part of the passivating contact material layer 21 located in the first region F is removed by using the part of the dielectric layer 22 covering the passivated contact region J, in the dielectric layer that has been patterned and formed with the marking structure, as a mask. The part of the passivating contact material layer 21 covering the passivated contact region J is retained. The dielectric layer 22 is subsequently removed to form the marking structure 40 into the marking portion 50. As a result, the marking portion 50 is finally formed on the part of the passivating contact material layer 21 covering the passivated contact region J, so that the passivation contact material around the marking portion 50 can be retained. Compared forming the marking portion on a first region F (without the passivating contact material), this method creates a significant difference in the reflection ability between the marking portion 50 and the circumjacent background structure, allowing image capturing mechanisms, such as a camera, to capture the position of the marking portion 50 more easily and more accurately, during the subsequent formation of the first electrode 81 at the position on the first passivation layer 60 covering the passivated contact region J with the marking portion 50 as a positioning reference. Thus, the first electrode 81 can be more accurately positioned, thereby improving the yield of the solar cell.

In should be noted that, in step S20, i.e., patterning the part of the dielectric layer 22 covering the first region F, and forming the marking structure 40 at the position on the dielectric layer 22 covering the passivated contact region J, the step of patterning the part of the dielectric layer 22 covering the first region F can be performed first, followed by the step of forming the marking structure 40 at the position on the dielectric layer 22 covering the passivated contact region J. Alternatively, the step of forming the marking structure 40 at the position on the dielectric layer 22 covering the passivated contact region J can be performed first, followed by the step of patterning the part of the dielectric layer 22 covering the first region F. Alternatively, the step of patterning the part of the dielectric layer 22 covering the first region F and the step of forming the marking structure 40 at the position on the dielectric layer 22 covering the passivated contact region J can be performed simultaneously.

In some embodiments of the present application, in step S20, the step of forming the marking structure 40 at the position on the dielectric layer 22 covering the passivated contact region J specifically includes:
locally scanning the position of the dielectric layer 22 covering the passivated contact region J with a first laser to form the marking structure 40.

In some embodiments, in step S20, the step of patterning the part of the dielectric layer 22 covering the first region F specifically includes:
entirely scanning the position of the dielectric layer 22 covering the first region F with a second laser.

A laser spot of the second laser can be larger than a laser spot of the first laser, and a laser power of the second laser can be higher than a laser power of the first laser.

In the process of laser scanning the part of the dielectric layer 22 covering the first region F and the passivated contact region J, the laser treatment area of the dielectric layer 22 covering the first region F is relatively large, requiring a large laser spot having a high power. If the same laser is used to treat the part of the dielectric layer 22 covering the passivated contact region J to form the marking structure 40, the large laser spot would lead to a marking structure 40 that is too large, which affects the passivation effect on the surface of the solar cell 100 and requires a relatively long treatment time. In addition, in the large-area laser ablation process, in order to make the laser ablation to be performed smoothly and uniformly, the laser spot needs to be shaped to ensure a uniform spot energy irradiated to the part of the dielectric layer 22 covering the first region F. As a result, the laser used for scanning the dielectric layer 22 covering the first region F may have a large spot size, high energy, and good uniformity (needing to be shaped). However, using such a laser with these characteristics for scanning the part of the dielectric layer 22 covering the passivated contact region J could result in a high manufacturing cost due to the high laser cost, and potentially degrade the passivation performance at the marking structure 40.

In the above-described technical solution, the two independent lasers, i.e., the second laser and the first laser, are used to perform the laser treatments on the parts of the dielectric layer 22 covering the first region F and the passivated contact region J, respectively, wherein the laser spot size of the second laser is greater than the laser spot size of the first laser, and the laser power of the second laser is higher than the laser power of the first laser. The first laser with a smaller spot size and a lower laser power not only reduces the cost, but also ensures that a marking portion 50 with a smaller area can be finally formed by the smaller laser spot, which eventually improves the passivation performance of the solar cell 100. Specifically, for example, the first laser can be an infrared laser, and the second laser can be a green picosecond laser. The infrared laser is used as the first laser to perform the laser treatment on the part of the dielectric layer 22 covering the passivated contact region J to form the marking structure 40, so as to avoid the issue of multiple repeat treatments needed with the low energy green picosecond laser, thus further improving the production capacity. Meanwhile, the green picosecond laser is used as the second laser to perform the laser treatment on the part of the dielectric layer 22 covering the first region F. Therefore, the two positions can be efficiently processed by separate steps, improving the passivation performance of the solar cell 100.

In some embodiments of the present application, the first laser has a spot diameter of less than 120 µm and a power ranging from 10 W to 100 W, optionally from 10 W to 15 W. It can be understood that the energy can also be enhanced by increasing the overlap ratio. The second laser has a spot diameter of greater than 150 µm, and a power ranging from 40 W to 200 W, optionally from 60 W to 80 W. Specifically, the first laser can be a Gaussian beam, or have a shaped laser spot, for example, a square spot or the like. Since the first laser is used for forming the marking structure 40, the requirements for the spot of the first laser, especially for uniformity, are slightly lower than those for the spot of the second laser, allowing the use of an unshaped Gaussian beam to reduce the cost.

In some embodiments of the present application, the step of locally scanning the position of the dielectric layer 22 covering the passivated contact region J with the first laser specifically includes:
reciprocally scanning the dielectric layer 22 in a first path and reciprocally scanning the dielectric layer 22 in a second path with the first laser to form the marking structure 40 with a cross-shaped outer contour in the dielectric layer 22, wherein the first path and the second path intersect with each other and are both straight-line paths.

Alternatively, in another embodiment, the first laser can scan the dielectric layer 22 along an annular path to form the marking structure 40 with an annular outer contour.

Alternatively, in some other embodiments, the first laser can scan the dielectric layer 22 in a circular region to form the marking structure 40 with a circular outer contour.

In some embodiments of the present application, with reference to FIGs. 1, 16, and 17, the marking portion 50 includes a first groove 51.

In step S30, i.e., removing the part of the passivating contact material layer 21 located in the first region by using the part of the dielectric layer 22 covering the passivated contact region J, in the dielectric layer 22 that has been patterned and has been formed with the marking structure 40, as the mask, and then removing the dielectric layer 22 to form the marking structure 40 into the marking portion 50 include:
wet etching to remove the part of the passivating contact material layer 21 located in the first region F, and removing the patterned dielectric layer 22, thereby forming the first groove 51 in the passivating contact material layer 21 covering the passivated contact region J. After the part of the passivating contact material layer 21 located in the first region F is removed, the remaining passivating contact material layer 21 forms a first passivating contact structure 20 and a second passivating contact structure 30 that cover the passivated contact region J.

Further, the marking structure 40 further includes a transitional treatment region 52 located at an edge of an opening of the first groove 51. The first laser has greater energy intensity at a central local area of the laser spot than that at an edge area of the laser spot.

Through the wet etching, in the passivating contact material layer 21, a part of the region treated by the central local area of the laser spot forms the first groove 51, and the other part of the region treated by the central local area and the region treated by the edge area of the laser spot form the transitional treatment region 52, the transitional treatment region 52 includes a fusion formed from the materials of the dielectric layer 22, the passivating contact material layer 21, and the substrate 10. Alternatively, through the wet etching, in the passivating contact material layer 21, the region treated by the central local area of the laser spot forms the first groove 51, and the region treated by the edge area of the laser spot forms the transitional treatment region 52.

In an optional embodiment, the first laser can be a Gaussian beam, which has greater energy intensity at the central local area of the laser spot than that at the edge area of the laser spot. Other types of light beams can also be used, as long as the energy intensity at the central local area of the laser spot is greater than that at the edge area of the laser spot for the first laser.

In some embodiments of the present application, further, after the wet etching described above, a third structure 53 is formed around the marking structure 40. The reflectivity of the surface of the third structure 53 away from the substrate 10 is greater than the reflectivity of the surface of the passivating contact material layer 21 away from the substrate 10.

It should be understood that, when the marking structure 40 is formed by using the first laser, as shown in FIG. 16, the marking structure 40 can already include the first groove 51, the transitional treatment region 52, and the third structure 53. The subsequent wet etching can further remove the impurities, so as to form a relatively clear marking portion 50.

Alternatively, the first laser only melts the layers in the region where the first groove 51 is to be formed, and forms the transitional treatment region 52 and the third structure 53. The subsequent wet etching removes the melted portion, thereby forming the first groove 51 and finally forming the marking portion 50.

As shown in FIG. 17, as described above, the third structure 53 refers to a structure formed by the fusion of the layers sputtered around the marking structure 40 during the laser ablation. After the wet etching, the reflectivity of the surface of the third structure 53 is greater than those of the first passivating contact structure 20 and the second passivating contact structure 30, which is convenient for capturing by a camera.

In some embodiments of the present application, the step of removing the part of the passivating contact material layer 21 located in the first region F by using the part of the dielectric layer 22 covering the passivated contact region J, in the dielectric layer 22 that has been patterned and has formed with the marking structure 40, as the mask includes:
inwardly etching the substrate 10 in the first region F in a thickness direction of the substrate 10 to form a height difference D2. As described above in the description of the solar cell 100, the inward diffusion layer in the substrate 10 can be thus removed to some extent.

Further, in step S20, the step of patterning the part of the dielectric layer 22 covering the first region F includes:
modifying the part of the dielectric layer 22 covering the first region F; and
the step of removing the part of the passivating contact material layer 21 located in the first region F by using the part of the dielectric layer 22 covering the passivated contact region J, in the dielectric layer 22 that has been patterned and has been formed with the marking structure 40, as the mask specifically includes:
wet etching to remove the part of the dielectric layer 22 covering the first region F and the part of the passivating contact material layer 21 located in the first region F.

Alternatively, as shown in FIGs. 16 and 17, the step of patterning the part of the dielectric layer 22 covering the first region includes:
removing the part of the dielectric layer 22 covering the first region F; and
the step of removing the part of the passivating contact material layer 21 located in the first region F by using the part of the dielectric layer 22 covering the passivated contact region J, in the dielectric layer 22 that has been patterned and has been formed with the marking structure 40, as the mask specifically includes:
wet etching to remove the part of the passivating contact material layer 21 located in the first region F.

In some embodiments of the present application, the method for preparing a solar cell further includes a step of cutting the solar cell 100 into a plurality of solar cell bodies in a thickness direction thereof, wherein some solar cell bodies that are formed by cutting include zero marking portion 50, and some other solar cell bodies include one or more marking portions 50.

Hereinafter, the method for preparing a solar cell according to an embodiment of the present application will be described with reference to a specific example:
Step 1: As shown in FIG. 15, a passivating contact material layer 21 and a dielectric layer 22 are sequentially formed and stacked on a first surface Y of a substrate 10. The first surface Y of the substrate 10 includes a passivated contact region J and a first region F. The dielectric layer 22 can, for example, be naturally formed during the formation of the passivating contact material layer 21. For example, when the passivating contact material layer 21 includes a phosphorus doped polysilicon material layer 212, the dielectric layer 22 can be phosphosilicate glass (PSG).
Step 2: As shown in FIGs. 16 and 19, the part of the dielectric layer 22 covering the first region F is removed by using a second laser, and a marking structure 40 is formed at a position on the dielectric layer 22 covering the passivated contact region J by using the first laser, wherein the marking structure 40 at least extends into the passivating contact material layer 21.
Step 3: As shown in FIGs. 17 and 20, the part of the passivating contact material layer 21 located in the first region F is removed by wet etching using the patterned dielectric layer 22 as a mask, i.e., the part of the dielectric layer 22 covering the passivated contact region J in the dielectric layer 22 that has been patterned and has been formed with the marking structure 40 is used as the mask. The part of the passivating contact material layer 21 located in the passivated contact region J is retained to form a first passivating contact structure 20 and a second passivating contact structure 30. The patterned dielectric layer 22 is removed to form a first groove 51 in the passivating contact material layer 21 covering the passivated contact region J, form a transitional treatment region 52 around the first groove 51, and form a third structure 53 around the transitional treatment region 52, thereby forming a marking portion 50. It should be noted that the first groove 51 can have a continuous or discontinuous groove structure in its extending direction.
Step 4: As shown in FIGs. 5, 18, and 21, a first passivation layer 60 is formed on a side of the first passivating contact structure 20 and the second passivating contact structure 30 away from the substrate 10. A first electrode 81 is formed at a position on the first passivation layer 60 covering the passivated contact region J with the marking portion 50 as a positioning reference. The first electrode 81 can penetrate the first passivation layer 60 to be in contact with the first passivating contact structure 20.

FIG. 21 shows the thicknesses of the marking portion 50 in a direction R perpendicular to the extending direction of the marking portion 50. A point on a side of the first groove 51 is defined as a zero point O, the horizontal axis L1 represents the distance from the zero point O, and the vertical axis L2 represents the thickness of the solar cell 100 at each position. As can be seen from FIG. 21, a protrusion structure 511 is formed in the first groove 51, and the first groove 51 is significantly depressed relative to the surrounding transitional treatment region 52, so that the first groove 51 can be easily captured by the camera.

It should be understood that the method for forming the solar cell 100 shown in FIG. 1 can further include, for example, a step of forming a doped conductive layer 90 on a second surface E of the substrate 10 prior to step 1, a step of forming a second passivation layer 70 on a surface of the doped conductive layer 90 away from the substrate 10, and a step of forming a second electrode 82 on the second passivation layer 70 after step 4.

Some embodiments of the present application further provide a photovoltaic module and a photovoltaic system. The photovoltaic module includes at least one cell string, and the cell string includes at least two solar cells 100 as described above. The solar cells 100 can be connected together by series welding.

The photovoltaic system includes the above-described photovoltaic module. The photovoltaic system can be applied to photovoltaic power stations, such as ground power stations, roof power stations, water surface power stations, etc., and can be applied to equipment or devices that use solar energy to generate electricity, such as user solar power supplies, solar street lights, solar cars, solar buildings, etc. It should be understood that the application scenarios of the photovoltaic system are not limited to the above, in other words, the photovoltaic system can be applied in all fields that need to use solar energy to generate electricity. Taking a photovoltaic power generation network as an example, the photovoltaic system can include a photovoltaic array, a combiner box, and an inverter. The photovoltaic array can be an array of multiple photovoltaic modules. For example, the multiple photovoltaic modules can form multiple photovoltaic arrays. The photovoltaic arrays are connected to the combiner box, which can combine the electrical currents generated by the photovoltaic arrays. The combined electrical current flows through the inverter and is converted into the alternating current suitable for the urban power grid, and then connected to the urban power grid to realize solar power supply.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present disclosure.

The above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the patent protection of the present disclosure shall be defined by the appended claims.

## Claims

1. A solar cell, comprising:
a substrate (10) comprising a first surface (Y);
a passivating contact structure (200) disposed on a part of the first surface; and
a first electrode (81) disposed on a side of the passivating contact structure away from the substrate and electrically connected to the passivating contact structure;
wherein a marking portion (50) is disposed on a part of the passivating contact structure.

2. The solar cell according to claim 1, wherein the first electrode comprises a plurality of first sub-electrodes (810) and a plurality of second sub-electrodes (811), the plurality of first sub-electrodes are spaced apart from each other in a first direction (B), each of the plurality of first sub-electrodes is connected to at least two second sub-electrodes, and the at least two second sub-electrodes are spaced apart from each other in a second direction (C);
the marking portion is at least partially located between two adjacent second sub-electrodes, and the two adjacent second sub-electrodes are connected to a same first sub-electrode; and
the first direction and the second direction intersect with each other and are both perpendicular to a thickness direction of the solar cell;
optionally, wherein the marking portion is spaced apart from the two second sub-electrodes adjacent to the marking portion, or
optionally, an orthographic projection of the marking portion on the first surface is in contact or overlaps with an orthographic projection of at least one of the two second sub-electrode adjacent to the marking portion on the first surface.

3. The solar cell according to claim 1 or 2, wherein the first surface comprises one or a plurality of first regions (F) and one or a plurality of passivated contact regions (J);
the passivating contact structure comprises one or a plurality of first passivating contact structures (20) and one or a plurality of second passivating contact structures (30);
the first passivating contact structure and the second passivating contact structure are respectively disposed in the one or a plurality of passivated contact regions, and an orthographic projection of the second passivating contact structure does not overlap with an orthographic projection of the first passivating contact structure on the first surface;
the first electrode is disposed on a side of the first passivating contact structure away from the substrate; and
the marking portion is disposed on the second passivating contact structure;
optionally, edges of the plurality of first passivating contact structures define a plurality of accommodation regions (G); and
each second passivating contact structure is located in a corresponding accommodation region;
further optionally, the plurality of first passivating contact structures are spaced apart from each other;
each first passivating contact structure comprises a first contact region (2011) and a plurality of second contact regions (2012) extending from the first contact region in a direction away from the first contact region; and
the accommodation region is defined between two adjacent second contact regions, and the two adjacent second contact regions are connected to a same first contact region;
further optionally, a plurality of first contact regions of the plurality of first passivating contact structures are spaced apart from each other in a first direction, the plurality of second contact regions connected to the same first contact region are spaced apart from each other in a second direction (C), and the first direction and the second direction intersect with each other and are both perpendicular to a thickness direction of the solar cell;
further optionally, the first electrode comprises a plurality of first sub-electrodes (810) and a plurality of second sub-electrodes (811), each first sub-electrode is connected to at least two second sub-electrodes, and the at least two second sub-electrodes are spaced apart from each other in the second direction;
the plurality of first sub-electrodes are disposed on the plurality of first contact regions in one-to-one correspondence and located at a surface of the plurality of first contact regions away from the substrate, and the plurality of second sub-electrodes are disposed on the plurality of second contact regions in one-to-one correspondence and located at a surface of the plurality of second contact regions away from the substrate;
the second passivating contact structure is located between two adjacent second sub-electrodes which are adjacent in the second direction.

4. The solar cell according to claim 3, wherein the first passivating contact structure and the second passivating contact structure are spaced apart from each other or in contact with each other.

5. The solar cell according to claim 3 or 4, wherein the marking portion is spaced apart from an edge of a corresponding second passivating contact structure.

6. The solar cell according to any one of claims 3 to 5, wherein the marking portion is a plurality of marking portions; and
the plurality of marking portions are configured to locate a geometric center of the solar cell.

7. The solar cell according to any one of claims 3 to 6, wherein the marking portion comprises a first groove (51);
the first groove extends to an interior of the second passivating contact structure; or
the first groove extends to and terminated at a boundary position between the second passivating contact structure and the first surface in the passivated contact region in a thickness direction of the solar cell; or
the first groove extends to an interior of the substrate corresponding to the passivated contact region.

8. The solar cell according to claim 7, wherein the first groove extends into the substrate corresponding to the passivated contact region, and a maximum vertical distance D1 between a bottom wall of the first groove and the first surface in the passivated contact region satisfies: D1>1 µm.

9. The solar cell according to claim 7 or 8, wherein the bottom wall of the first groove comprises a central region and an over-etched region adjacent to an edge of the central region;
a height of the over-etched region relative to a second surface (E) of the substrate is lower than a height of the central region relative to the second surface; and
the second surface is opposite to the first surface.

10. The solar cell according to any one of claims 7 to 9, wherein a width W1 of the first groove satisfies: W1<100 µm.

11. The solar cell according to any one of claims 7 to 10, wherein the marking portion further comprises a transitional treatment region (52) located between an edge of an opening of the first groove and an edge of an adjacent second passivating contact structure; and
a reflectivity of a surface of the transitional treatment region away from the substrate is greater than a reflectivity of a surface of the second passivating contact structure away from the substrate;
optionally, a surface of the transitional treatment region away from the substrate comprises a plurality of protrusions, and heights of the plurality of projections relative to the second surface of the substrate gradually increase from the edge of the opening of the first groove to the edge of the adjacent second passivating contact structure; and/or optionally, a roughness of the surface of the transitional treatment region away from the substrate is smaller than a roughness of the surface of the second passivating contact structure away from the substrate; and/or
optionally, the transitional treatment region comprises a fusion of a first material and a second material;
the first material is a passivating contact material from the second passivating contact structure, and the second material is a substrate material from the substrate; and/or optionally, the surface of the transitional treatment region away from the substrate is lower than the surface of the second passivating contact structure away from the substrate by D0, where 50 nm<D0< 1 µm; and/or
optionally, a size W2 of the marking portion in a width direction of the first groove satisfies: W2<120 µm.

12. The solar cell according to any one of claims 7 to 11, further comprising a third structure (53) disposed on the surface of the second passivating contact structure away from the substrate; and
the third structure is disposed around the marking portion, and a reflectivity of a surface of the third structure away from the substrate is greater than the reflectivity of the surface of the second passivating contact structure away from the substrate;
optionally, the reflectivity of the surface of the third structure away from the substrate, the reflectivity of the surface of the transitional treatment region away from the substrate, and the reflectivity of the bottom wall of the first groove increase in sequence.

13. The solar cell according to any one of claims 7 to 12, wherein an outer contour of the first groove is in a circular or annular shape; or
the first groove comprises at least two groove segments (510) intersecting with each other.

14. The solar cell according to any one of claims 3 to 13, wherein the first surface in the first region is more adjacent to a second surface of the substrate than the first surface in the passivated contact region, and the second surface is opposite to the first surface;
optionally, a vertical distance D2 between the first surface in the first region and the first surface in the passivated contact region satisfies: D2>1 µm;
further optionally, the marking portion comprises a first groove, and a vertical distance D1 between a bottom wall of the first groove and the first surface in the passivated contact region and D2 satisfies: D2≤D1.

15. A method for preparing a solar cell, comprising:
providing a panel (101) comprising a substrate (10), a passivating contact material layer (21), and a dielectric layer (22), the passivating contact material layer and the dielectric layer being sequentially stacked on a first surface (Y) of the substrate, the first surface of the substrate comprising a first region (F) and a passivated contact region (J);
patterning a part of the dielectric layer covering the first region, and forming a marking structure (40) at a position on the dielectric layer covering the passivated contact region, the marking structure extending at least into the passivating contact material layer;
removing a part of the passivating contact material layer located in the first region by using the part of the dielectric layer covering the passivated contact region, in the dielectric layer that has been patterned and has been formed with the marking structure, as a mask and removing the dielectric layer to form the marking structure into a marking portion (50); and
forming a first passivation layer (60) on a side of the passivating contact material layer away from the substrate, and forming a first electrode (81) at a position on the first passivation layer covering the passivated contact region by using the marking portion as a positioning reference.

## Amended claims

### Amended claims in accordance with Rule 137(2) EPC.

**1.** A solar cell, comprising:
a substrate (10) comprising a first surface (Y);
a passivating contact structure (200) disposed on a part of the first surface; and
a first electrode (81) disposed on a side of the passivating contact structure away from the substrate and electrically connected to the passivating contact structure;
wherein a marking portion (50) is disposed on a part of the passivating contact structure.

**2.** The solar cell according to claim 1, wherein the first electrode comprises a plurality of first sub-electrodes (810) and a plurality of second sub-electrodes (811), the plurality of first sub-electrodes are spaced apart from each other in a first direction (B), each of the plurality of first sub-electrodes is connected to at least two second sub-electrodes, and the at least two second sub-electrodes are spaced apart from each other in a second direction (C);
the marking portion is at least partially located between two adjacent second sub-electrodes, and the two adjacent second sub-electrodes are connected to a same first sub-electrode; and
the first direction and the second direction intersect with each other and are both perpendicular to a thickness direction of the solar cell;
optionally, wherein the marking portion is spaced apart from the two second sub-electrodes adjacent to the marking portion, or
optionally, an orthographic projection of the marking portion on the first surface is in contact or overlaps with an orthographic projection of at least one of the two second sub-electrode adjacent to the marking portion on the first surface.

**3.** The solar cell according to claim 1 or 2, wherein the first surface comprises one or a plurality of first regions (F) and one or a plurality of passivated contact regions (J);
the passivating contact structure comprises one or a plurality of first passivating contact structures (20) and one or a plurality of second passivating contact structures (30), and at least one of the first passivating contact structure and the second passivating contact structure comprises a first tunneling oxide layer (201) and a first conductive doped polysilicon layer (202) stacked on each other, and the first tunneling oxide layer is disposed on the first surface;
the first passivating contact structure and the second passivating contact structure are respectively disposed in the one or a plurality of passivated contact regions, and an orthographic projection of the second passivating contact structure does not overlap with an orthographic projection of the first passivating contact structure on the first surface;
the first electrode is disposed on a side of the first passivating contact structure away from the substrate; and
the marking portion is disposed on the second passivating contact structure;
optionally, edges of the plurality of first passivating contact structures define a plurality of accommodation regions (G); and
each second passivating contact structure is located in a corresponding accommodation region; further optionally, the plurality of first passivating contact structures are spaced apart from each other;
each first passivating contact structure comprises a first contact region (2011) and a plurality of second contact regions (2012) extending from the first contact region in a direction away from the first contact region; and
the accommodation region is defined between two adjacent second contact regions, and the two adjacent second contact regions are connected to a same first contact region;
further optionally, a plurality of first contact regions of the plurality of first passivating contact structures are spaced apart from each other in a first direction, the plurality of second contact regions connected to the same first contact region are spaced apart from each other in a second direction (C), and the first direction and the second direction intersect with each other and are both perpendicular to a thickness direction of the solar cell;
further optionally, the first electrode comprises a plurality of first sub-electrodes (810) and a plurality of second sub-electrodes (811), each first sub-electrode is connected to at least two second sub-electrodes, and the at least two second sub-electrodes are spaced apart from each other in the second direction;
the plurality of first sub-electrodes are disposed on the plurality of first contact regions in one-to-one correspondence and located at a surface of the plurality of first contact regions away from the substrate, and the plurality of second sub-electrodes are disposed on the plurality of second contact regions in one-to-one correspondence and located at a surface of the plurality of second contact regions away from the substrate;
the second passivating contact structure is located between two adjacent second sub-electrodes which are adjacent in the second direction.

**4.** The solar cell according to claim 3, wherein the first passivating contact structure and the second passivating contact structure are spaced apart from each other or in contact with each other.

**5.** The solar cell according to claim 3 or 4, wherein the marking portion is spaced apart from an edge of a corresponding second passivating contact structure.

**6.** The solar cell according to any one of claims 3 to 5, wherein the marking portion is a plurality of marking portions; and
the plurality of marking portions are configured to locate a geometric center of the solar cell.

**7.** The solar cell according to any one of claims 3 to 6, wherein the marking portion comprises a first groove (51);
the first groove extends to an interior of the second passivating contact structure; or
the first groove extends to and terminated at a boundary position between the second passivating contact structure and the first surface in the passivated contact region in a thickness direction of the solar cell; or
the first groove extends to an interior of the substrate corresponding to the passivated contact region.

**8.** The solar cell according to claim 7, wherein the first groove extends into the substrate corresponding to the passivated contact region, and a maximum vertical distance D1 between a bottom wall of the first groove and the first surface in the passivated contact region satisfies: D1>1 µm.

**9.** The solar cell according to claim 7 or 8, wherein the bottom wall of the first groove comprises a central region and an over-etched region adjacent to an edge of the central region;
a height of the over-etched region relative to a second surface (E) of the substrate is lower than a height of the central region relative to the second surface; and
the second surface is opposite to the first surface.

**10.** The solar cell according to any one of claims 7 to 9, wherein a width W1 of the first groove satisfies: W1<100 µm.

**11.** The solar cell according to any one of claims 7 to 10, wherein the marking portion further comprises a transitional treatment region (52) located between an edge of an opening of the first groove and an edge of an adjacent second passivating contact structure; and
a reflectivity of a surface of the transitional treatment region away from the substrate is greater than a reflectivity of a surface of the second passivating contact structure away from the substrate; optionally, a surface of the transitional treatment region away from the substrate comprises a plurality of protrusions, and heights of the plurality of projections relative to the second surface of the substrate gradually increase from the edge of the opening of the first groove to the edge of the adjacent second passivating contact structure; and/or
optionally, a roughness of the surface of the transitional treatment region away from the substrate is smaller than a roughness of the surface of the second passivating contact structure away from the substrate; and/or
optionally, the transitional treatment region comprises a fusion of a first material and a second material;
the first material is a passivating contact material from the second passivating contact structure, and the second material is a substrate material from the substrate; and/or
optionally, the surface of the transitional treatment region away from the substrate is lower than the surface of the second passivating contact structure away from the substrate by D0, where 50 nm<D0<1 µm; and/or
optionally, a size W2 of the marking portion in a width direction of the first groove satisfies: W2<120 µm.

**12.** The solar cell according to any one of claims 7 to 11, further comprising a third structure (53) disposed on the surface of the second passivating contact structure away from the substrate; and
the third structure is disposed around the marking portion, and a reflectivity of a surface of the third structure away from the substrate is greater than the reflectivity of the surface of the second passivating contact structure away from the substrate;
optionally, the reflectivity of the surface of the third structure away from the substrate, the reflectivity of the surface of the transitional treatment region away from the substrate, and the reflectivity of the bottom wall of the first groove increase in sequence.

**13.** The solar cell according to any one of claims 7 to 12, wherein an outer contour of the first groove is in a circular or annular shape; or
the first groove comprises at least two groove segments (510) intersecting with each other.

**14.** The solar cell according to any one of claims 3 to 13, wherein the first surface in the first region is more adjacent to a second surface of the substrate than the first surface in the passivated contact region, and the second surface is opposite to the first surface;
optionally, a vertical distance D2 between the first surface in the first region and the first surface in the passivated contact region satisfies: D2>1 µm;
further optionally, the marking portion comprises a first groove, and a vertical distance D1 between a bottom wall of the first groove and the first surface in the passivated contact region and D2 satisfies: D2≤D1.

**15.** A method for preparing a solar cell, comprising:
providing a panel (101) comprising a substrate (10), a passivating contact material layer (21), and a dielectric layer (22), the passivating contact material layer and the dielectric layer being sequentially stacked on a first surface (Y) of the substrate, the first surface of the substrate comprising a first region (F) and a passivated contact region (J);
patterning a part of the dielectric layer covering the first region, and forming a marking structure (40) at a position on the dielectric layer covering the passivated contact region, the marking structure extending at least into the passivating contact material layer;
removing a part of the passivating contact material layer located in the first region by using the part of the dielectric layer covering the passivated contact region, in the dielectric layer that has been patterned and has been formed with the marking structure, as a mask and removing the dielectric layer to form the marking structure into a marking portion (50); and
forming a first passivation layer (60) on a side of the passivating contact material layer away from the substrate, and forming a first electrode (81) at a position on the first passivation layer covering the passivated contact region by using the marking portion as a positioning reference.

**1.** A solar cell, comprising:
a substrate (10) comprising a first surface (Y);
a passivating contact structure (200) disposed on a part of the first surface; and
a first electrode (81) disposed on a side of the passivating contact structure away from the substrate and electrically connected to the passivating contact structure;
wherein a marking portion (50) is disposed on a part of the passivating contact structure;
wherein the first surface comprises one or a plurality of first regions (F) and one or a plurality of passivated contact regions (J);
the passivating contact structure comprises one or a plurality of first passivating contact structures (20) and one or a plurality of second passivating contact structures (30), and at least one of the first passivating contact structure and the second passivating contact structure comprises a first tunneling oxide layer (201) and a first conductive doped polysilicon layer (202) stacked on each other, and the first tunneling oxide layer is disposed on the first surface;
the first passivating contact structure and the second passivating contact structure are respectively disposed in the one or a plurality of passivated contact regions, and an orthographic projection of the second passivating contact structure does not overlap with an orthographic projection of the first passivating contact structure on the first surface;
the first electrode is disposed on a side of the first passivating contact structure away from the substrate; and
the marking portion is disposed on the second passivating contact structure.

**2.** The solar cell according to claim 1, wherein the first electrode comprises a plurality of first sub-electrodes (810) and a plurality of second sub-electrodes (811), the plurality of first sub-electrodes are spaced apart from each other in a first direction (B), each of the plurality of first sub-electrodes is connected to at least two second sub-electrodes, and the at least two second sub-electrodes are spaced apart from each other in a second direction (C);
the marking portion is at least partially located between two adjacent second sub-electrodes, and the two adjacent second sub-electrodes are connected to a same first sub-electrode; and
the first direction and the second direction intersect with each other and are both perpendicular to a thickness direction of the solar cell;
optionally, wherein the marking portion is spaced apart from the two second sub-electrodes adjacent to the marking portion, or
optionally, an orthographic projection of the marking portion on the first surface is in contact or overlaps with an orthographic projection of at least one of the two second sub-electrode adjacent to the marking portion on the first surface.

**3.** The solar cell according to claim 1 or 2, wherein
edges of the plurality of first passivating contact structures define a plurality of accommodation regions (G); and
each second passivating contact structure is located in a corresponding accommodation region; optionally, the plurality of first passivating contact structures are spaced apart from each other;
each first passivating contact structure comprises a first contact region (2011) and a plurality of second contact regions (2012) extending from the first contact region in a direction away from the first contact region; and
the accommodation region is defined between two adjacent second contact regions, and the two adjacent second contact regions are connected to a same first contact region;
further optionally, a plurality of first contact regions of the plurality of first passivating contact structures are spaced apart from each other in a first direction, the plurality of second contact regions connected to the same first contact region are spaced apart from each other in a second direction (C), and the first direction and the second direction intersect with each other and are both perpendicular to a thickness direction of the solar cell;
further optionally, the first electrode comprises a plurality of first sub-electrodes (810) and a plurality of second sub-electrodes (811), each first sub-electrode is connected to at least two second sub-electrodes, and the at least two second sub-electrodes are spaced apart from each other in the second direction;
the plurality of first sub-electrodes are disposed on the plurality of first contact regions in one-to-one correspondence and located at a surface of the plurality of first contact regions away from the substrate, and the plurality of second sub-electrodes are disposed on the plurality of second contact regions in one-to-one correspondence and located at a surface of the plurality of second contact regions away from the substrate;
the second passivating contact structure is located between two adjacent second sub-electrodes which are adjacent in the second direction.

**4.** The solar cell according to claim 1, wherein the first passivating contact structure and the second passivating contact structure are spaced apart from each other or in contact with each other.

**5.** The solar cell according to any one of claims 1 to 4, wherein the marking portion is spaced apart from an edge of a corresponding second passivating contact structure.

**6.** The solar cell according to any one of claims 1 to 5, wherein the marking portion is a plurality of marking portions; and
the plurality of marking portions are configured to locate a geometric center of the solar cell.

**7.** The solar cell according to any one of claims 1 to 6, wherein the marking portion comprises a first groove (51);
the first groove extends to an interior of the second passivating contact structure; or
the first groove extends to and terminated at a boundary position between the second passivating contact structure and the first surface in the passivated contact region in a thickness direction of the solar cell; or
the first groove extends to an interior of the substrate corresponding to the passivated contact region.

**8.** The solar cell according to claim 7, wherein the first groove extends into the substrate corresponding to the passivated contact region, and a maximum vertical distance D1 between a bottom wall of the first groove and the first surface in the passivated contact region satisfies: D1>1 µm.

**9.** The solar cell according to claim 7 or 8, wherein the bottom wall of the first groove comprises a central region and an over-etched region adjacent to an edge of the central region;
a height of the over-etched region relative to a second surface (E) of the substrate is lower than a height of the central region relative to the second surface; and
the second surface is opposite to the first surface.

**10.** The solar cell according to any one of claims 7 to 9, wherein a width W1 of the first groove satisfies: W1<100 µm.

**11.** The solar cell according to any one of claims 7 to 10, wherein the marking portion further comprises a transitional treatment region (52) located between an edge of an opening of the first groove and an edge of an adjacent second passivating contact structure; and
a reflectivity of a surface of the transitional treatment region away from the substrate is greater than a reflectivity of a surface of the second passivating contact structure away from the substrate; optionally, a surface of the transitional treatment region away from the substrate comprises a plurality of protrusions, and heights of the plurality of projections relative to the second surface of the substrate gradually increase from the edge of the opening of the first groove to the edge of the adjacent second passivating contact structure; and/or
optionally, a roughness of the surface of the transitional treatment region away from the substrate is smaller than a roughness of the surface of the second passivating contact structure away from the substrate; and/or
optionally, the transitional treatment region comprises a fusion of a first material and a second material;
the first material is a passivating contact material from the second passivating contact structure, and the second material is a substrate material from the substrate; and/or
optionally, the surface of the transitional treatment region away from the substrate is lower than the surface of the second passivating contact structure away from the substrate by D0, where 50 nm<D0<1 µm; and/or
optionally, a size W2 of the marking portion in a width direction of the first groove satisfies: W2<120 µm.

**12.** The solar cell according to any one of claims 7 to 11, further comprising a third structure (53) disposed on the surface of the second passivating contact structure away from the substrate; and
the third structure is disposed around the marking portion, and a reflectivity of a surface of the third structure away from the substrate is greater than the reflectivity of the surface of the second passivating contact structure away from the substrate;
optionally, the reflectivity of the surface of the third structure away from the substrate, the reflectivity of the surface of the transitional treatment region away from the substrate, and the reflectivity of the bottom wall of the first groove increase in sequence.

**13.** The solar cell according to any one of claims 7 to 12, wherein an outer contour of the first groove is in a circular or annular shape; or
the first groove comprises at least two groove segments (510) intersecting with each other.

**14.** The solar cell according to any one of claims 1 to 13, wherein the first surface in the first region is more adjacent to a second surface of the substrate than the first surface in the passivated contact region, and the second surface is opposite to the first surface;
optionally, a vertical distance D2 between the first surface in the first region and the first surface in the passivated contact region satisfies: D2>1 µm;
further optionally, the marking portion comprises a first groove, and a vertical distance D1 between a bottom wall of the first groove and the first surface in the passivated contact region and D2 satisfies: D2≤D1.

**15.** A method for preparing the solar cell according to any one of claims 1 to 14, comprising:
providing a panel (101) comprising a substrate (10), a passivating contact material layer (21), and a dielectric layer (22), the passivating contact material layer and the dielectric layer being sequentially stacked on a first surface (Y) of the substrate, the first surface of the substrate comprising a first region (F) and a passivated contact region (J);
patterning a part of the dielectric layer covering the first region, and forming a marking structure (40) at a position on the dielectric layer covering the passivated contact region, the marking structure extending at least into the passivating contact material layer;
removing a part of the passivating contact material layer located in the first region by using the part of the dielectric layer covering the passivated contact region, in the dielectric layer that has been patterned and has been formed with the marking structure, as a mask and removing the dielectric layer to form the marking structure into a marking portion (50); and
forming a first passivation layer (60) on a side of the passivating contact material layer away from the substrate, and forming a first electrode (81) at a position on the first passivation layer covering the passivated contact region by using the marking portion as a positioning reference.
